# EUROPEAN PATENT SPECIFICATION

(11) **EP 4 362 641 B1**
(45) Date of publication and mention of the grant of the patent: **13.08.2025**
(21) Application number: 23204940.3
(22) Date of filing: 20.10.2023
(51) Int. Cl.: H10K 59/123, H10K 59/80

(54) **DISPLAY PANEL AND METHOD OF MANUFACTURING DISPLAY PANEL**
ANZEIGETAFEL UND VERFAHREN ZUR HERSTELLUNG EINER ANZEIGETAFEL
PANNEAU D'AFFICHAGE ET PROCÉDÉ DE FABRICATION DE PANNEAU D'AFFICHAGE

(30) Priority: 24.10.2022 KR 20220137579
(43) Date of publication of application: 01.05.2024
(73) Proprietor: Samsung Display Co., Ltd., Yongin-si, Gyeonggi-do (KR)
(72) Inventor: PARK, Juchan, Yongin-si (KR); KO, Yoomin, Yongin-si (KR); KIM, Sunho, Yongin-si (KR); KIM, Hyewon, Yongin-si (KR); PARK, Jonghee, Yongin-si (KR); LEE, Pilsuk, Yongin-si (KR); CHOI, Chung Sock, Yongin-si (KR); HONG, Sungjin, Yongin-si (KR)
(74) Representative: Marks & Clerk LLP

(56) References cited:
- JP-A- 2015 122 198
- US-A1- 2003 146 711

## Description

### BACKGROUND

### 1. Technical Field

The disclosure herein relates to a display panel and a method for manufacturing the display panel, and more, to a display panel with improved reliability, and a method for manufacturing the display panel.

### 2. Description of the Related Art

Multimedia electronic devices such as televisions, mobile phones, tablet computers, computers, navigation system units, and game consoles are equipped with a display panel for displaying images.

The display panel may include a light emitting element and a pixel driver for driving the light emitting element. In order to improve the reliability of the display panel, research is underway on the connection of the light emitting element and the circuit.

US 2003/146711 A1 and JP 2015/122198 A disclose OLED displays where the top electrode is connected to the transistor by a connection wiring.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein.

### SUMMARY

The disclosure provides a display panel with reduced afterimage defects, improved lifespan, and improved electrical reliability.

The technical objectives to be achieved by the disclosure are not limited to those described herein, and other technical objectives that are not mentioned herein would be clearly understood by a person skilled in the art from the description of the disclosure.

An embodiment provides a display panel that may include a transistor; a light emitting element including a first electrode; a light emitting layer disposed on the first electrode; and a second electrode disposed on the light emitting layer, ; the second electrode being electrically connected to the transistor; and a connection wiring electrically connecting the transistor and the second electrode, the connection wiring may include a first connected portion electrically connected to the second electrode; a second connected portion electrically connected to the transistor; and an extension portion extended from the first connected portion and electrically connecting the first connected portion and the second connected portion, each of the first connected portion, the second connected portion, and the extension portion may include a second layer, and a third layer disposed on the second layer; the second connected portion and the extension portion include a first tip portion, and the first connected portion may include a second tip portion, each of the first tip portion and the second tip portion is defined as a portion in which an end of the third layer protrudes further outward than an end of the second layer, and protruding lengths of the first tip portion and the second tip portion are different from each other.

In an embodiment, an insulation layer may be disposed on the connection wiring, and the insulation layer may include an open region exposing a portion of the first connected portion.

In an embodiment, the first connected portion may include the first tip portion, and the second tip portion may be defined in the open region.

In an embodiment, the first tip portion may not overlap the open region in a plan view, and the protrusion length of the second tip portion may be greater than the protrusion length of the first tip portion.

In an embodiment, the open region may include open regions, and the second tip portion may include second tip portions corresponding to the open regions.

In an embodiment, the first connected portion may include first sub-connected portions, and the first sub-connected portions may be electrically connected to each other.

In an embodiment, the insulation layer may include a sub-open region exposing a portion of at least one of the first sub-connected portions, and the second tip portion may be defined in the sub-open region.

In an embodiment, the first sub-connected portion may include the first tip portion, and the first tip portion may not overlap the sub-open region in a plan view.

In an embodiment, the first connected portion may include an extension portion electrically connecting the first sub-connected portions.

In an embodiment, the sub-extension portion may include the first tip portion.

In an embodiment, the sub-open region may include sub-open regions, and the second tip portion may include second tip portions corresponding to the sub-open regions.

In an embodiment, the second electrode may be partially disconnected by the second tip portion, and a first end and a second end which are disconnected may be defined in the second electrode.

In an embodiment, a first layer may be disposed below the second layer, wherein the first end may come in contact with the first layer and the second layer at the second tip portion, and the second end may be disposed on the third layer.

In an embodiment, the first connected portion, the extension portion, and the second connected portion may be disposed on a same layer.

In an embodiment, a method for manufacturing a display panel may include forming a driving element layer including a transistor and a first insulation layer on a base layer; forming a contact-hole partially exposing the transistor ; providing a connection wiring electrically connected to the transistor through the contact-hole on the first insulation layer; forming a first tip portion by a primary etching on the connection wiring; providing a second insulation layer covering the connection wiring; forming a first open region on the second insulation layer to partially expose the first tip portion, thereby providing the first tip portion exposed by the first open region as a second preliminary tip portion; and forming a second tip portion by a secondary etching on the second preliminary tip portion, wherein the connection wiring may include a first layer, a second layer disposed on the first layer, and a third layer disposed on the second layer, in each of the first tip portion and the second tip portion, an end of the third layer protrudes from an end of the second layer, and protrusion lengths of the first tip portion and second tip portion are different from each other.

In an embodiment, the method for manufacturing a display panel may further include forming a first electrode on the second insulation layer; forming a pixel definition film on which a second open region exposing the second tip portion and a pixel opening exposing the first electrode are defined; and providing a light emitting layer and a second electrode on the first electrode, wherein the providing of a second electrode may include electrically connecting the second electrode to the second tip portion.

In an embodiment, the providing of a second preliminary tip portion may include exposing the first tip portion.

In an embodiment, the connection wiring may include a first connected portion electrically connected to the second electrode, a second connected portion electrically connected to the transistor, and an extension portion extended from the first connected portion and electrically connecting the first connected portion and the second connected portion.

In an embodiment, the forming of a first tip portion may include etching the first connected portion, the extension portion, and the second connected portion, and the forming of a second tip portion may include etching a side of the first connected portion.

In an embodiment, the primary etching time and the secondary etching time may be different from each other.

In an embodiment, the time for the secondary etching may be longer than the time for the primary etching, and the protrusion length of the second tip portion may be greater than the protrusion length of the first tip portion.

At least some of the above features that accord with the invention and other features according to the invention are set out in the claims.

### BRIEF DESCRIPTION OF THE DRAWINGS

The accompanying drawings are included to provide a further understanding of the disclosure, and are incorporated in and constitute a part of this specification. The drawings illustrate embodiments of the disclosure and, together with the description, serve to explain principles of the disclosure. In the drawings:
FIG. 1 is a block diagram of a display device according to an embodiment;
FIG. 2A is a schematic diagram of an equivalent circuit of a pixel according to an embodiment;
FIG. 2B is a schematic diagram of an equivalent circuit of a pixel according to an embodiment;
FIG. 3A shows schematic plan views illustrating display devices according to an embodiment;
FIG. 3B shows schematic plan views illustrating display devices according to an embodiment;
FIG. 4A is a schematic plan view of an enlarged partial region of a display panel according to an embodiment;
FIG. 4B is a schematic plan view of an enlarged partial region of a display panel according to an embodiment;
FIG. 4C is a schematic plan view of an enlarged partial region of a display panel according to an embodiment;
FIG. 5 is a schematic cross-sectional view of a display panel according to an embodiment;
FIG. 6A is a schematic cross-sectional view showing region BB illustrated in FIG. 5;
FIG. 6B is a schematic cross-sectional view showing region CC illustrated in FIG. 5;
FIG. 7 is a schematic plan view showing region AA illustrated in FIG. 4A;
FIG. 8A is a schematic cross-sectional view showing a light emitting connected portion corresponding to line II - II ' of FIG. 7;
FIG. 8B is a schematic cross-sectional view showing a light emitting connected portion corresponding to line III-III' of FIG. 7;
FIG. 9 is a schematic plan view showing a light emitting connected portion according to an embodiment;
FIG. 10A is a schematic cross-sectional view showing a light emitting connected portion corresponding to line IV-IV' of FIG. 9;
FIG. 10B is a schematic cross-sectional view showing a light emitting connected portion corresponding to line V-V' of FIG. 9;
FIG. 11A is a schematic plan view showing a light emitting connected portion according to an embodiment;
FIG. 11B is a schematic cross-sectional view showing a light emitting connected portion corresponding to line VI-VI' of FIG. 11A; and
FIG. 12A to FIG. 12H are process diagrams showing steps of manufacturing a display panel according to an embodiment.

### DETAILED DESCRIPTION OF THE EMBODIMENTS

The disclosure may be modified in many alternate forms, and thus embodiments will be illustrated in the drawings and described in detail. It should be understood, however, that it is not intended to limit the disclosure to the particular forms disclosed, but rather, is intended to cover all modifications, equivalents, and alternatives falling within the scope of the claims.

In the disclosure, when an element (or a region, a layer, a portion, etc.) is referred to as being "on," "connected to," or "coupled to" another element, it means that the element may be directly disposed on/connected to/coupled to the other element, or that a third element or other elements may be disposed therebetween.

Like reference numerals refer to like elements. Also, in the drawings, the thickness, the ratio, and the dimensions of elements are exaggerated for an effective description of technical contents.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or."

It will be understood that, although the terms "first," "second," etc. may be used herein to describe various elements, these elements should not be limited by these terms. These terms are only used to distinguish one element from another. For example, a first element may be referred to as a second element, and a second element may also be referred to as a first element in a similar manner without departing the scope of rights of the disclosure.

As used herein, the singular forms, "a," "an," and "the" are intended to include the plural forms as well, unless the context clearly indicates otherwise.

In addition, terms such as "below," "lower," "above," "upper," and the like are used to describe the relationship of components shown in the drawings. The terms are used as a relative concept and are described with reference to the direction indicated in the drawings but are not limited thereto.

For the purposes of this disclosure, the phrase "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z. The term "overlap" or "overlapped" means that a first object may be above or below or to a side of a second object, and vice versa.

Additionally, the term "overlap" may include layer, stack, face or facing, extending over, covering, or partly covering or any other suitable term as would be appreciated and understood by those of ordinary skill in the art. The expression "not overlap" may include meaning such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Unless otherwise defined or implied herein, all terms (including technical and scientific terms) used herein have the same meaning as commonly understood by one of ordinary skill in the art to which the disclosure pertains. It is also to be understood that terms defined in commonly used dictionaries should be interpreted as having meanings consistent with the meanings in the context of the related art, and are expressly defined herein and should not be interpreted in an ideal or overly formal sense unless so defined or implied herein.

It should be understood that terms "comprises," "comprising," "includes," and/or "including,", "has," "have," and/or "having," and variations thereof when used in this specification, specify the presence of stated features, integers, steps, operations, elements, components, and/or groups thereof, but do not preclude the presence or addition of one or more other features, integers, steps, operations, elements, components, and/or groups thereof.

Hereinafter, embodiments of the disclosure will be described with reference to the accompanying drawings.

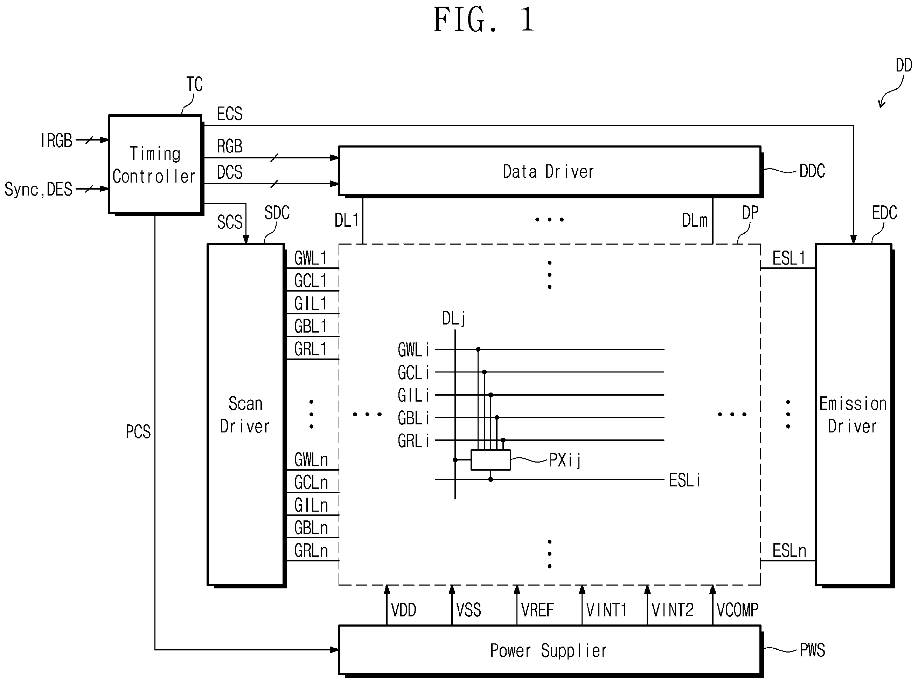

FIG. 1 is a block diagram of a display device DD according to an embodiment.

Referring to FIG. 1, the display device DD may include a timing controller TC, a panel driver, and a display panel DP. In an embodiment, the display panel DP will be described as being a light emitting type display panel. The light emitting type display panel DP may include an organic light emitting display panel, an inorganic light emitting display panel, or a quantum dot light emitting display panel. In the following embodiment to be described, an organic light emitting display panel will be described in detail as an example. The panel driver may include a scan driver SDC, an emission driver EDC, and a data driver DDC.

The display panel DP may include scan lines GWL1 to GWLn, GCL1 to GCLn, GIL1 to GILn, GBL1 to GBLn, and GRL1 to GRLn, emission lines ESL1 to ESLn, and data lines DL1 to DLm. The display panel DP may include pixels PXij connected to the scan lines GWL1 to GWLn, GCL1 to GCLn, GIL1 to GILn, GBL1 to GBLn, and GRL1 to GRLn, the emission lines ESL1 to ESLn, and the data lines DL1 to DLm. (wherein, m and n are integers greater than 1).

For example, a pixel PXij (wherein i and j are integers greater than 1) positioned at an i-th horizontal line (or, an i-th pixel row) and a j-th vertical line (or, a j-th pixel column) may be connected to an i-th first scan line GWLi, an i-th second scan line GCLi, an i-th third scan line GILi, an i-th fourth scan line GBLi, an i-th fifth scan line GRLi, a j-th data line DLj, and an i-th emission line ESLi.

The pixel PXij may include transistors and capacitors. The pixel PXij may be supplied with a first power voltage VDD (or a first driving voltage), a second power voltage VSS (or a second driving voltage), a third power voltage VREF (or a reference voltage), a fourth power voltage VINT1 (or a first initialization voltage), a fifth power voltage VINT2 (or a second initialization voltage), and a sixth power voltage VCOMP (or a compensation voltage) through a power supplier PWS.

The voltage values of the first power voltage VDD and the second power voltage VSS are set such that a current flows in the light emitting element to emit light. For example, the first power voltage VDD may be set to a voltage higher than the second power voltage VSS.

The third power voltage VREF may be a voltage for initializing a gate of a driving transistor included in the pixel PXij. The third power voltage VREF may be used to implement a selectable gray scale by using a voltage difference with a data signal. To this end, the third power voltage VREF may be set to a selectable voltage within a voltage range of the data signal.

The fourth power voltage VINT1 may be a voltage for initializing a capacitor included in the pixel PXij. The fourth power voltage VINT1 may be set to a voltage lower than the third power voltage VREF. For example, the fourth power voltage VINT1 may be set to a voltage lower than a difference between the third power voltage VREF and a threshold voltage Vth of the driving transistor. For example, the fourth power voltage VINT1 may be set to 4 V to 12 V. In case that the fourth power voltage VINT1 is set to a potential of 4 V or greater, it may be readily possible to overcome characteristics of an N-type transistor. However, an embodiment is not limited thereto.

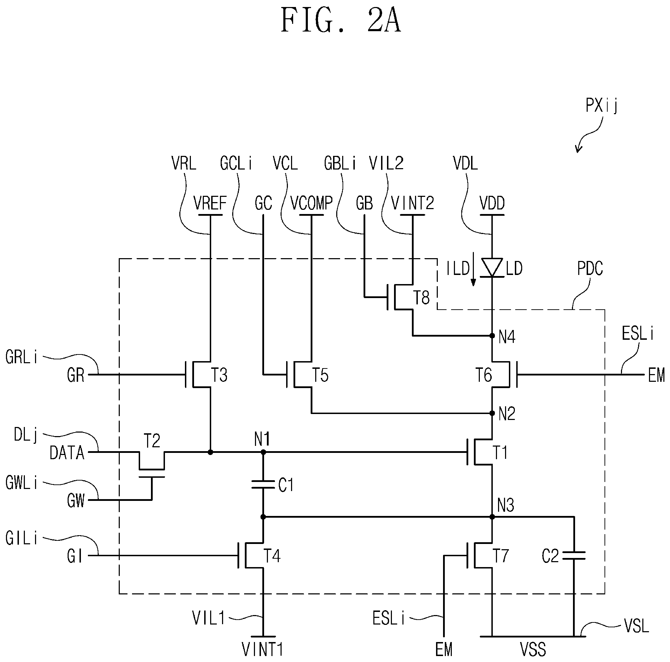

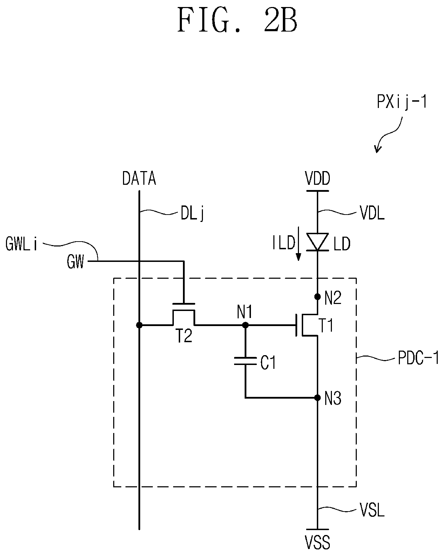

The fifth power voltage VINT2 may be a voltage for initializing a cathode of a light emitting element LD (see FIG. 2A or FIG. 2B) included in the pixel PXij.

The sixth power voltage VCOMP may supply a selectable current to the driving transistor in case that the threshold voltage of the driving transistor is compensated. The fifth power voltage VINT2 may be set to a voltage lower than the first power voltage VDD or the fourth power voltage VINT1 or may be set to a voltage similar to or the same as the third power voltage VREF, but an embodiment is not limited thereto, and the fifth power voltage VINT2 may be set to a voltage similar to or the same as the first power voltage VDD.

FIG. 1 illustrates that the first to sixth power voltages VDD, VSS, VREF, VINT1, VINT2, and VCOMP are all supplied from the power supplier PWS, but an embodiment is not limited thereto. For example, the first power voltage VDD and the second power voltage VSS are all supplied regardless of a structure of the pixel PXij, and at least one of the third power voltage VREF, the fourth power voltage VINT1, the fifth power voltage VINT2, and the sixth power voltage VCOMP may not be supplied in correspondence to the structure of the pixel PXij.

In an embodiment, signal lines connected to the pixel PXij may be variously set in correspondence to a structure of the pixel PXij.

The scan driver SDC may receive a first control signal SCS from the timing controller TC, and may supply a scan signal to each of the first scan lines GWL1 to GWLn, the second scan lines GCL1 to GCLn, the third scan lines GIL1 to GILn, the fourth scan lines GBL1 to GBLn, and the fifth scan lines GRL1 to GRLn based on the first control signal SCS.

The scan signal may be set to a gate-on voltage such that transistors which are supplied with the scan signal may be turned on.

For example, a scan signal supplied to a P-type transistor may be set to a logic low level, and a scan signal supplied to an N-type transistor may be set to a logic high level. Hereinafter, the meaning of "a scan signal is supplied" may be understood as that a scan signal is supplied at a logic level which turns on a transistor controlled by the scan signal.

In FIG. 1, for convenience of description, the scan driver SDC is illustrated as having a single configuration, but an embodiment is not limited thereto. According to an embodiment, scan drivers may be included to supply a scan signal to each of the first scan lines GWL1 to GWLn, the second scan lines GCL1 to GCLn, the third scan lines GIL1 to GILn, the fourth scan lines GBL1 to GBLn, and the fifth scan lines GRL1 to GRLn.

The emission driver EDC may supply an emission signal to the emission lines ESL1 to ESLn based on a second control signal ECS. For example, the emission signal may be supplied sequentially to the emission lines ESL1 to ESLn.

Transistors connected to the emission lines ESL1 to ESLn of the disclosure may be N-type transistors. At this time, the emission signal supplied to the emission lines ESL1 to ESLn may be set to a gate-off voltage (for example, a logic high level). Transistors receiving an emission signal may be turned off in case that the emission signal is supplied, and may be set to the state of being turned-on otherwise.

The second control signal ECS may include an emission start signal and clock signals, and the emission driver EDC may be implemented as a shift register which sequentially shifts the emission start signal in a pulse form using the clock signals so as to sequentially generate and output an emission signal in a pulse form.

The data driver DDC may receive a third control signal DCS and image data RGB from the timing controller TC. The data driver DDC may convert the image data RGB in a digital form into an analog data signal (for example, a data signal). The data driver DDC may supply a data signal to the data lines DL1 to DLm in correspondence to the third control signal DCS.

The third control signal DCS may include a data enable signal, a horizontal start signal, a data clock signal, and the like, which indicate the output of a valid data signal. For example, the data driver DDC may include a shift register configured to shift a horizontal start signal in synchronization with a data clock signal to generate a sampling signal, a latch configured to latch the image data RGB in response to the sampling signal, a digital-to-analog converter (or, a decoder) configured to convert the latched image data (for example, data in a digital form) into data signals in an analog form, and buffers (or, amplifiers) configured to output the data signals to the data lines DL1 to DLm.

The power supplier PWS may supply the first power voltage VDD, the second power voltage VSS, and the third power voltage VREF for driving the pixel PXij to the display panel DP. The power supplier PWS may supply at least one voltage of the fourth power voltage VINT1 and the fifth power voltage VINT2 to the display panel DP.

As an example, the power supplier PWS may respectively supply the first power voltage VDD, the second power voltage VSS, the third power voltage VREF, the fourth power voltage VINT1, the fifth power voltage VINT2, and the sixth power voltage VCOMP to the display panel DP via a first power line VDL, a second power line VSL, a third power line VRL (or a reference power line), a fourth power line VIL1 (or a first initialization power line), a fifth power line VIL2 (or a second initialization power line), and a sixth power line VCL (or a compensation line), which are illustrated in FIG. 2A.

The power supplier PWS may be implemented as a power management IC (PMIC), but is not limited thereto.

The timing controller TC may generate the first control signal SCS, the second control signal ECS, the third control signal DCS, and a fourth control signal PCS based on input image data IRGB, a synchronization signal Sync (for example, a vertical synchronization signal, a horizontal synchronization signal, etc.), a data enable signal DES, a clock signal, etc. The first control signal SCS may be supplied to the scan driver SDC, the second control signal ECS may be supplied to the emission driver EDC, the third control signal DCS may be supplied to the data driver DDC, and the fourth control signal PCS may be supplied to the power supplier PWS. The timing controller TC may generate the image data RGB (or, frame data) by rearranging the input image data IRGB in correspondence to an arrangement of the pixel PXij in the display panel DP.

The scan driver SDC, the emission driver EDC, the data driver DDC, the power supplier PWS, and/or the timing controller TC may be directly formed on the display panel DP, or may be provided in the form of a separate driving chip and be connected to the display panel DP. At least two among the scan driver SDC, the emission driver EDC, the data driver DDC, the power supplier PWS, and the timing controller TC may be provided as one driving chip. For example, the data driver DDC and the timing controller TC may be provided as one driving chip.

In the above, the display device DD according to an embodiment disclosure has been described with reference to FIG. 1, but a display device of the disclosure is not limited thereto. Signal lines may be further added or omitted according to the configuration of a pixel. The connection relationship between one pixel and signal lines may be changed. In case that any one of the signal lines is omitted, another signal line may replace the omitted signal line.

FIG. 2A and FIG. 2B are schematic diagrams of equivalent circuits of a pixel according to an embodiment. FIG. 2A and FIG. 2B illustrate schematic diagrams of equivalent circuits of pixels PXij and PXij-1 connected to the i-th first scan line GWLi (hereinafter, a first scan line) and connected to the j-th data line DLj (hereinafter, a data line).

As illustrated in FIG. 2A, the pixel PXij may include a light emitting element LD and a pixel driver PDC. The light emitting element LD is connected to the first driving voltage line VDL and to the pixel driver PDC.

The pixel driver PDC may be connected to the scan lines GWLi, GCLi, GILi, GBLi, and GRLi, the data line DLj, the emission line ESLi, and the power voltage lines VDL, VSL, VIL1, VIL2, VRL, and VCL. The pixel driver PDC may include first to eighth transistors T1, T2, T3, T4, T5, T6, T7, and T8, a first capacitor C1, and a second capacitor C2. Hereinafter, a case in which each of the first to eighth transistors T1, T2, T3, T4, T5, T6, T7, and T8 is an N-type transistor will be described as an example. However, an embodiment is not limited thereto, and some or a number of the first to eighth transistors T1 to T8 may be N-type transistors, and the rest thereof may be P-type transistors, or each of the first to eighth transistors T1 to T8 may be a P-type transistor, and an embodiment is not limited to any one embodiment.

A gate of the first transistor T1 may be connected to a first node N1. A first electrode of the first transistor T1 may be connected to a second node N2, and a second electrode thereof may be connected to a third node N3. The first transistor T1 may be a driving transistor. The first transistor T1 may control a driving current ILD flowing from the first driving voltage line VDL to the second driving voltage line VSL via light emitting element LD in correspondence to a voltage of the first node N1. At this time, the first driving voltage VDD may be set to a voltage having a potential higher than that of the second driving voltage VSS.

In the disclosure, "being electrically connected between a transistor and a signal line or between a transistor and a transistor" means that "a source, a drain, and a gate of the transistor have a shape of a single body with the signal line, or are connected through a connection electrode."

The second transistor T2 may include a gate connected to the first scan line GWLi, a first electrode connected to the data line DLj, and a second electrode connected to the first node N1. The second transistor T2 may supply a data signal DATA to the first node N1 in response to a write scan signal GW transmitted through the first scan line GWLi. The second transistor T2 may be a switching transistor. The second transistor T2 may be turned on in case that the first scan signal GW is supplied to the first scan line GWLi and electrically connect the data line DLj and the first node N1.

The third transistor T3 may be connected between the first node N1 and the reference voltage line VRL. A first electrode of the third transistor T3 may receive the reference voltage VREF through the reference voltage line VRL, and a second electrode of the third transistor T3 may be connected to the first node N1. In an embodiment, a gate of the third transistor T3 may receive a reset scan signal GR through the i-th fifth scan line GRLi (hereinafter, a fifth scan line). The third transistor T3 may be turned on in case that the reset scan signal GR is supplied to the fifth scan line GRLi and provide the reference voltage VREF to the first node N1.

The fourth transistor T4 may be connected between the third node N3 and the first initialization voltage line VIL1. A first electrode of the fourth transistor T4 may be connected to the third node N3, and a second electrode of the fourth transistor T4 may be connected to a first initialization voltage line VIL1 which provides the first initialization voltage VINT1. A gate of the fourth transistor T4 may receive an initialization scan signal GI through the i-th third scan line GILi (hereinafter, a third scan line). The fourth transistor T4 may be turned on in case that the initialization scan signal GI is supplied to the third scan line GILi and supply the first initialization voltage VINT1 to the third node N3.

The fifth transistor T5 may be connected between the compensation power line VCL and the second node N2. A first electrode of the fifth transistor T5 may receive the compensation voltage VCOMP through the compensation voltage line VCL, and a second electrode of the fifth transistor T5 may be connected to the second node N2 to be electrically connected to the first electrode of the first transistor T1. A gate of the fifth transistor T5 may receive a compensation scan signal GC through the i-th second scan line GCLi (hereinafter, a second scan line). The fifth transistor T5 may be turned on in case that the compensation scan signal GC is supplied to the second scan line GCLi and provide the compensation voltage VCOMP to the second node N2, and during a compensation period, a threshold voltage Vth of the first transistor T1 may be compensated.

The sixth transistor T6 may be connected between the first transistor T1 and the light emitting element LD. By way of example, a gate of the sixth transistor T6 may receive an emission signal EM through the i-th emission line ESLi (hereinafter, an emission line). A first electrode of the sixth transistor T6 may be connected to a cathode of the light emitting element LD through a fourth node N4, and a second electrode of the sixth transistor T6 may be connected to the first electrode of the first transistor T1 through the second node N2. The sixth transistor T6 may be referred to as a first emission control transistor. The sixth transistor T6 may be turned on in case that the emission signal EM is supplied to the emission line ESLi, and electrically connect the light emitting element LD and the first transistor T1.

The seventh transistor T7 may be connected between the second driving voltage line VSL and the third node N3. A first electrode of the seventh transistor T7 may be connected to the second electrode of the first transistor T1 through the third node N3, and a second electrode of the seventh transistor T7 may receive the second driving voltage VSS through the second driving voltage line VSL. A gate of the seventh transistor T7 may be electrically connected to the emission line ESLi. The seventh transistor T7 may be referred to as a second emission control transistor. The seventh transistor T7 may be turned on in case that the emission signal EM is supplied to the emission line ESLi, and electrically connect the first electrode of the first transistor T1 and the second driving voltage line VSL.

In an embodiment, the sixth transistor T6 and the seventh transistor T7 are illustrated as being connected to the same emission line ESLi and turned on through the same emission signal EM, but this is an illustrated example, and the sixth transistor T6 and the seventh transistor T7 may be independently turned on by different signals distinguished from each other. In the pixel driver PDC according to an embodiment, one of the sixth transistor T6 and the seventh transistor T7 may be omitted.

The eighth transistor T8 may be connected between the second initialization voltage line VIL2 and the fourth node N4. For example, the eighth transistor T8 may include a gate connected to the i-th fourth scan line GBLi (hereinafter, a fourth scan line), a first electrode connected to the second initialization voltage line VIL2, and a second electrode connected to the fourth node N4. The eighth transistor T8 may be referred to as a second initialization transistor. The eighth transistor T8 may supply the second initialization voltage VINT2 to the fourth node N4 corresponding to the cathode of the light emitting element LD in response to a black scan signal GB transmitted through the fourth scan line GBLi. The cathode of the light emitting element LD may be initialized by the second initialization voltage VINT2.

In an embodiment, some or a number of the second to eighth transistors T2, T3, T4, T5, T6, T7, and T8 may be simultaneously turned on through the same scan signal. For example, the eighth transistor T8 and the fifth transistor T5 may be simultaneously turned on through the same scan signal. For example, the eighth transistor T8 and the fifth transistor T5 may be operated through the same compensation scan signal GC. The eighth transistor T8 and the fifth transistor T5 are turned on/off by the same compensation scan signal GC, so that the eighth transistor T8 and the fifth transistor T5 may be simultaneously turned on/off. The second scan line GCLi and the fourth scan line GBLi may be provided as substantially a single scan line. Accordingly, initializing the cathode of the light emitting element LD and compensating the threshold voltage of the first transistor T1 may be performed at the same timing. However, this is an illustrated example, and an embodiment is not limited to any one embodiment.

According to the disclosure, the initialization the cathode of the light emitting element LD and the compensation the threshold voltage of the first transistor T1 may be achieved with the application of the same power voltage. For example, the compensation voltage line VCL and the second initialization voltage line VIL2 may be provided as substantially a single power voltage line. Since the initialization operation of a cathode and the compensation operation of a driving transistor may be performed with one power voltage, the design of a driver may be simplified. However, this is an illustrated example, and an embodiment is not limited to any one embodiment.

The first capacitor C1 may be disposed between the first node N1 and the third node N3. The first capacitor C1 may store a voltage difference between the first node N1 and the third node N3. The first capacitor C1 may be referred to as a storage capacitor.

The second capacitor C2 may be disposed between the third node N3 and the second driving voltage line VSL. For example, one electrode of the second capacitor C2 may be connected to the second driving voltage line VSL which is supplied with the second driving voltage VSS, and the other electrode of the second capacitor C2 may be connected to the third node N3. The second capacitor C2 may store a charge corresponding to a voltage difference between the second driving voltage line VSL and the third node N3. The second capacitor C2 may be referred to as a hold capacitor. The second capacitor C2 may have a higher storage capacity compared to the first capacitor C1. Accordingly, the second capacitor C2 may minimize a voltage change of the third node N3 in correspondence to a voltage change of the first node N1.

In an embodiment, the light emitting element LD may be connected to the pixel driver PDC through the fourth node N4. The light emitting element LD may include an anode connected to the first driving voltage line VDL and a cathode facing the anode. In an embodiment, the light emitting element LD may be connected to the pixel driver PDC through the cathode. For example, in the pixel PXij according to the disclosure, a connection node to which the light emitting element LD and the pixel driver PDC are connected may be the fourth node N4, and the fourth node N4 may correspond to a connection node between the first electrode of the sixth transistor T6 and the cathode of the light emitting element LD.

Accordingly, the potential of the fourth node N4 may substantially correspond to the potential of the cathode of the light emitting element LD. For example, the anode of the light emitting element LD may be connected to the first driving voltage line VDL and applied with the first driving voltage VDD, which is a constant voltage, and the cathode thereof may be connected to the first transistor T1 though the sixth transistor T6. For example, the potential of the second node N2 corresponding to a source of the first transistor T1 may not be directly affected by the characteristics of the light emitting element LD. Therefore, even if the characteristics of the light emitting element LD are deteriorated due to the lifespan of the light emitting element LD and the like, the influence on transistors constituting the pixel driver PDC, for example a gate-source voltage Vgs of a driving transistor, may be reduced. For example, since a change width of a current amount due to the deterioration of the light emitting element LD may be reduced, afterimage defects of the display panel due to an increase in usage time may be reduced and the lifespan thereof may be improved.

By way of example, as illustrated in FIG. 2B, the pixel PXij-1 may include a pixel driver PDC-1 including two transistors T1 and T2 and one capacitor C1. The pixel driver PDC-1 may be connected to a light emitting element LD, a first scan line GWLi, a data line DLj, and a second driving voltage line VSL. The pixel driver PDC-1 illustrated in FIG. 2B may correspond to the pixel driver PDC illustrated in FIG. 2A from which the third to eighth transistors T3 to T8 and one capacitor C2 may be omitted.

Each of the first and second transistors T1 and T2 may be an N-type transistor or a P-type transistor. In an embodiment, each of the first and second transistors T1 and T2 is described as an N-type transistor.

The first transistor T1 may include a gate connected to a first node N1, a first electrode connected to a second node N2, and a second electrode connected to a third node N3. The second node N2 may be a node connected to the side of a first driving voltage line VDL, and the third node N3 may be a node connected to the side of a second driving voltage line VSL. The first transistor T1 is connected to light emitting element LD through the second node N2 and connected to the second driving voltage line VSL through the third node N3. The first transistor T1 may be a driving transistor.

The second transistor T2 may include a gate for receiving a scan signal GW through the first scan line GWLi, a first electrode connected to the data line DLj, and a second electrode connected to the first node N1. The second transistor T2 may supply a data signal DATA to the first node N1 in response to a write scan signal GW transmitted through the first scan line GWLi.

The capacitor C1 may include an electrode connected to the first node N1 and an electrode connected to the third node N3. The capacitor C1 may store the data signal DATA transmitted to the first node N1.

The light emitting element LD may include an anode and a cathode. In an embodiment, the anode of the light emitting element LD is connected to the first driving voltage line VDL, and the cathode thereof is connected to the pixel driver PDC-1 through the second node N2. In an embodiment, the cathode of the light emitting element LD may be connected to the first transistor T1. The light emitting element LD may emit light in correspondence to an amount of current flowing in the first transistor T1 of the pixel driver PDC-1.

The second node N2 to which the cathode of light emitting element LD and the pixel driver PDC-1 are connected may correspond to a drain of the first transistor T1. The light emitting element LD may be connected to the pixel driver PDC-1 through the second node N2. For example, in the pixel PXij-1 illustrated in FIG. 2B, a connection node to which the light emitting element LD and the pixel driver PDC-1 are connected may be the second node N2, and the second node N2 may correspond to a connection node between the first electrode of the first transistor T1 and the cathode of the light emitting element LD.

For example, in case that the driving transistor is an N-type transistor, the display panel of the disclosure may prevent a change in a gate-source voltage of the first transistor T1 caused by the light emitting element LD. Accordingly, since a change width of a current amount due to the deterioration of the light emitting element LD may be reduced, afterimage defects of the display panel due to an increase in usage time may be reduced and the lifespan thereof may be improved.

FIG. 2A and FIG. 2B illustrate circuits for the pixel drivers PDC and PDC-1 according to an embodiment, and as long as a display panel according to an embodiment is a circuit connected to the cathode of the light emitting element LD, the number or arrangement relationship of transistors and the number or arrangement relationship of capacitors may be designed in various ways and are not limited to any one embodiment.

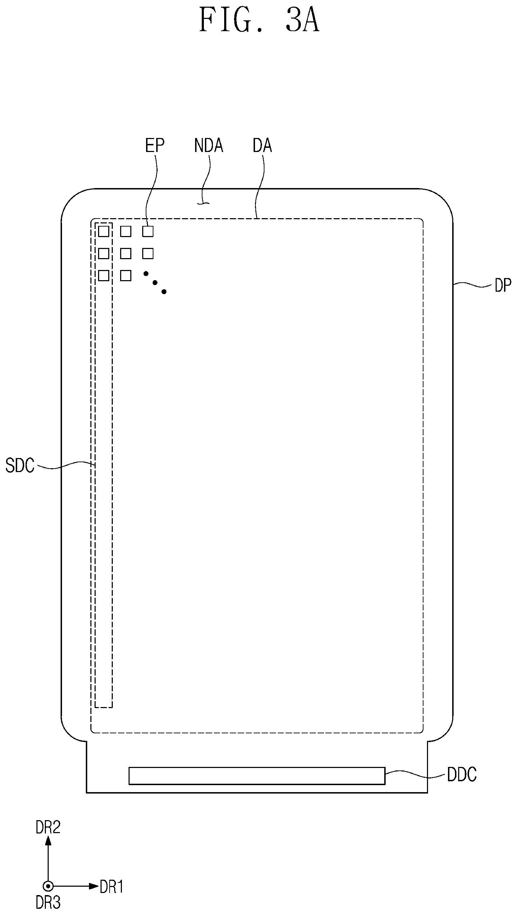

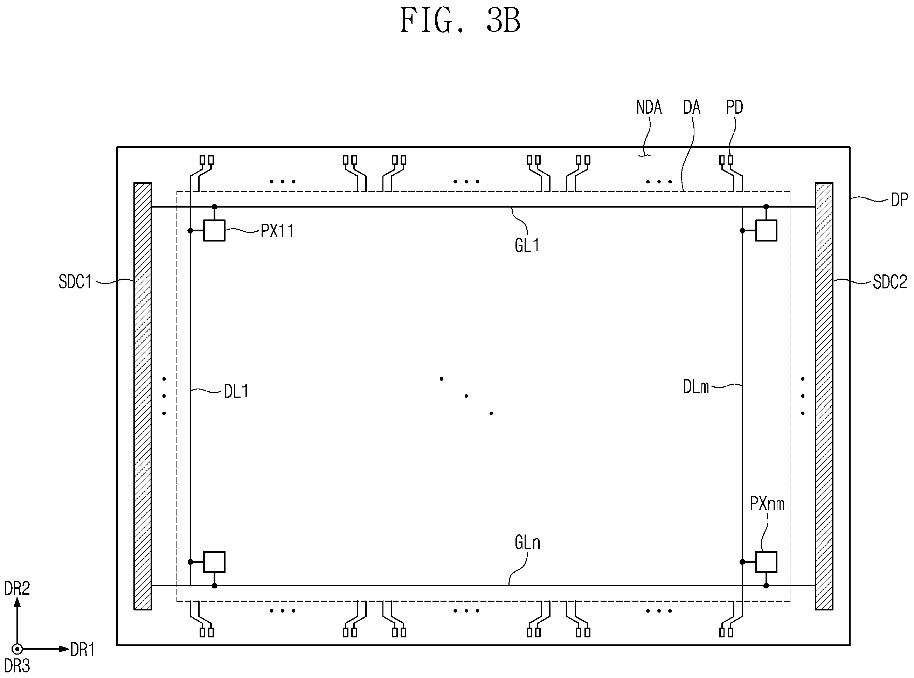

FIG. 3A and FIG. 3B are schematic plan views illustrating display devices according to an embodiment. In each of FIG. 3A and FIG. 3B, some components may be omitted. Hereinafter, the disclosure will be described with reference to FIG. 3A and FIG. 3B. Referring to FIG. 3A, the display panel DP of an embodiment may be divided into a display region DA and a peripheral region NDA. The display region DA may include light emitters EP.

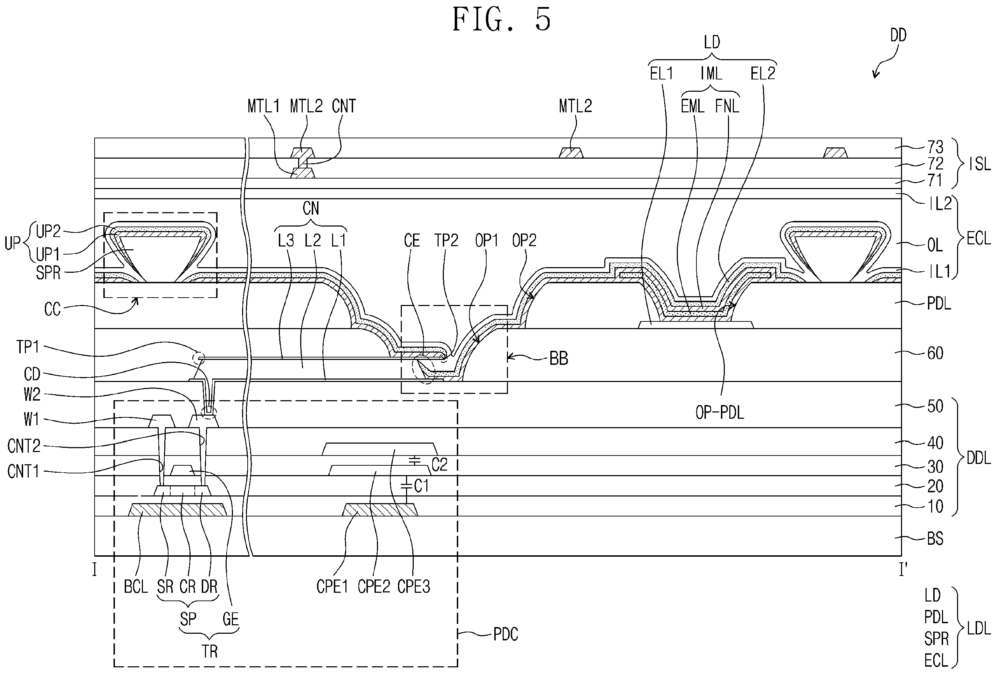

The light emitters EP may be regions each emitting light by the pixels PXij (see FIG. 1). By way of example, each of the light emitters EP may correspond to a light emitting opening OP-PDL (see FIG. 5) to be described later.

The peripheral region NDA may be disposed adjacent to the display region DA. In an embodiment, the peripheral region NDA is illustrated as having a shape surrounding the display region DA. However, this is only an example, and the peripheral region NDA may be disposed on one side or a side of the display region DA, or may be omitted, and is not limited to any one embodiment.

In an embodiment, the scan driver SDC and the data driver DDC may be mounted on the display panel DP. In an embodiment, the scan driver SDC may be disposed in the display region DA, and the data driver DDC may be disposed in the peripheral region NDA. The scan driver SDC may overlap at least some or a number of the light emitters EP disposed in the display region DA on a plane. Since the scan driver SDC is disposed in the display region DA, the area of the peripheral area NDA may be reduced in the disclosure as compared to a display panel in which a scan driver is disposed in a peripheral region, and a display device with a narrow bezel may be readily implemented.

In FIG. 3A, one scan driver SDC is illustrated, but an embodiment is not limited thereto. For example, the scan driver SDC may be provided as two portions separated from each other. The two scan drivers SDC may be disposed spaced apart from each other left and right with the center of the display region DA interposed therebetween. By way of example, the scan driver SDC may be provided in a number equal to or greater than 2, and is not limited to any one embodiment.

FIG. 3A illustrates an example of a display device, and the data driver DDC may be disposed in the display region DA. At this time, some or a number of the light emitters EP disposed in the display region DA may overlap the data driver DDC on a plane.

The data driver DDC may be provided in the form of a separate driving chip independent from the display panel DP and be connected to the display panel DP. However, this is a described example, and the data driver DDC may be formed in a process the same as the process in which the scan driver SDC is formed so as to constitute the display panel DP, and is not limited to any one embodiment.

By way of example, as illustrated in FIG. 3B, the display device may include a display panel having a longer long side in a first direction DR1. In an embodiment, the display device may include scan drivers SDC1 and SDC2. The scan drives SDC1 and SDC2 are illustrated as including a first scan driver SDC1 and a second scan drive SDC2 disposed spaced apart from each other in the first direction DR1.

The first scan driver SDC1 may be connected some or a number of scan lines GL1 to GLn, and the second scan driver SDC2 may be connected others of the scan lines GL1 to GLn. For example, the first scan driver SDC1 may be connected odd-numbered scan lines GL1 to GL2n-1 among the scan lines GL1 to GLn, and the second scan driver SDC2 may be connected even-numbered scan lines GL2 to GL2n among the scan lines GL1 to GLn.

For ease of description, FIG. 3B illustrates pads PD of the data lines DL1 to DLm. The pads PD may be defined at ends of the data lines DL1 to DLm. The data lines DL1 to DLm may be connected to the data driver DDC (see FIG. 3A) through the pads PD. FIG. 3B also includes pixels PX11 and PXnm and appropriate connections thereto.

According to the disclosure, the pads PD may be divided and arranged or disposed at positions spaced apart from each other with the display region DA interposed therebetween in the peripheral region NDA. For example, some or a number of the pads PD may be disposed on an upper side, for example, a side adjacent to the first scan line GL1 among the scan lines GL1 to GLn, and others of the pads PD may be disposed on a lower side, for example, a side adjacent to the last scan line GLn among the scan lines GL1 to GLn. In an embodiment, among the pads PD, pads connected to odd-numbered data lines DL1 to DL2m-1 may be disposed on an upper side, and among the pads PD, pads connected to even-numbered data lines DL2 to DL2m may be disposed on a lower side. Although not illustrated, the data driving unit may include three upper data drivers connected to the pads PD disposed on an upper side and three lower data drivers connected to the pads PD disposed on a lower side. However, this is a described example, and the pads PD according to an embodiment may be connected through two data drivers respectively provided on the upper side and the lower side. By way of example, the pads PD according to an embodiment may be disposed on any one side or a side and connected to a single data driver, and is not limited any one embodiment.

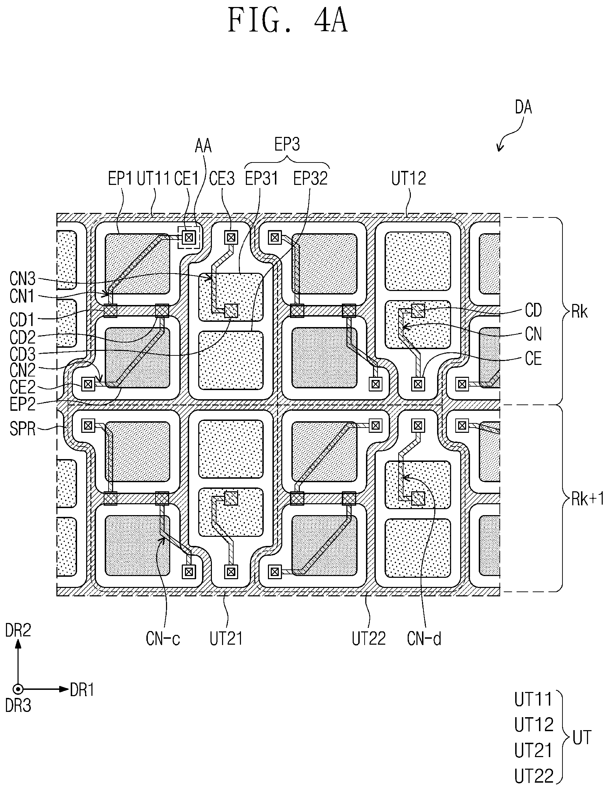

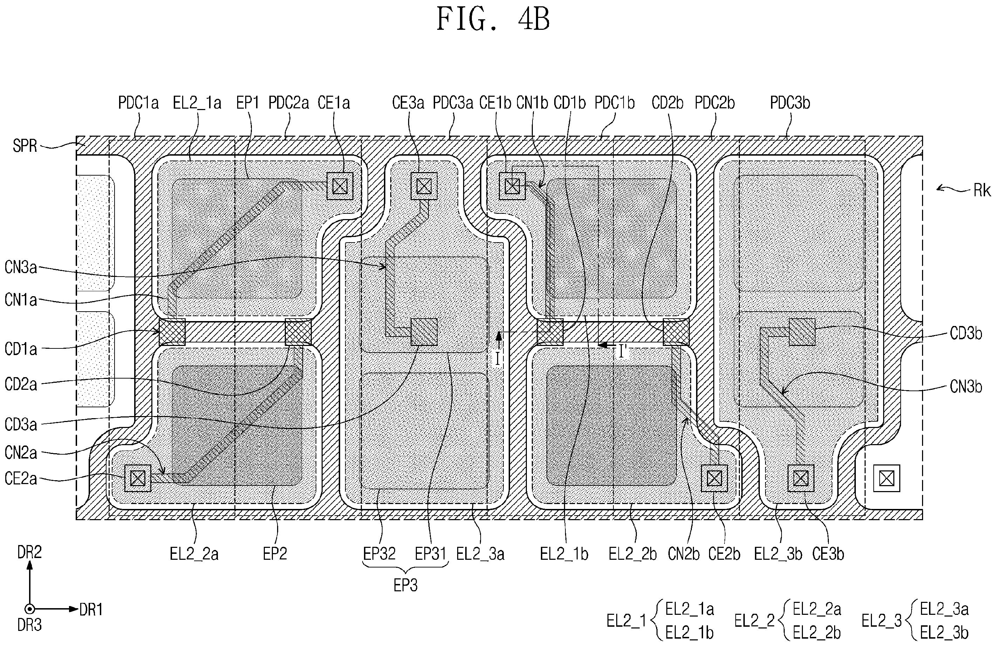

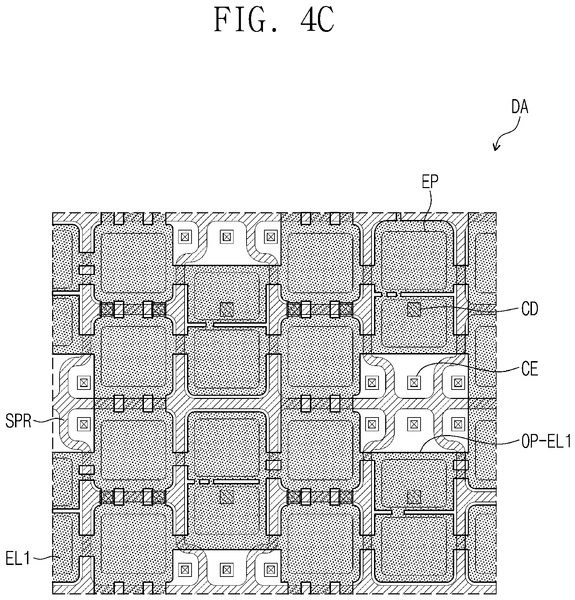

FIG. 4A to FIG. 4C are schematic plan views of or a number of enlarged regions of a display panel according to an embodiment. FIG. 4A illustrates a region in which a total of four light emitting units UT in two rows and two columns are disposed, and FIG. 4B illustrates enlarged light emitters of a first row Rk illustrated in FIG. 4A. FIG. 4C, a number of the components illustrated in FIG. 4A may be omitted or emphasized. Hereinafter, with reference to FIG. 4A to FIG. 4C, the disclosure will be described.

FIG. 4A illustrates light emitting units UT11, UT12, UT21, and UT22 in 2 rows and 2 columns. Light emitters of the first row Rk include light emitters constituting a first-row first-column light emitting unit UT11 and a first-row second-column light emitting unit UT12, and light emitters of a second row Rk+1 include light emitters constituting a second-row first-column light emitting unit UT21 and a second-row second-column light emitting unit UT22. Among components of a display panel, FIG. 4A to FIG. 4C illustrate a separator SPR, light emitters EP1, EP2, and EP3 disposed in a region partitioned by the separator SPR, connection wirings CN1, CN2, and CN3, a first electrode EL1, and second electrodes EL2_1, EL2_2, and EL2_3.

As described above, each of the light emitters EP1, EP2, and EP3 may correspond to a light emitting opening OP-PDL (see FIG. 5) to be described later. For example, each of the light emitters EP1, EP2, and EP3 may be regions from which light is emitted by the above-described light emitting element, and may correspond to a unit constituting an image displayed on the display panel DP. More by way of example, each of the light emitters EP1, EP2, and EP3 may correspond to a region defined by the light emitting opening OP-PDL to be described later, for example, a region defined by a lower surface of the light emitting opening OP-PDL.

The light emitters EP1, EP2, and EP3 may include a first light emitter EP1, a second light emitter EP2, and a third light emitter EP3. The first light emitter EP1, the second light emitter EP2, and the third light emitter EP3 may emit light of different colors from each other. For example, the first light emitter EP1 may emit red light, the second light emitter EP2 may emit green light, the third light emitter EP3 may emit blue light, but the combination of colors is not limited thereto. At least two or more among the light emitters EP1, EP2, and EP3 may emit light of the same color. For example, all of the first to third light emitters EP1, EP2, and EP3 may emit blue light, or all thereof may emit white light.

Among the light emitters EP1, EP2, and EP3, the third light emitter EP3 which displays light emitted by a third light emitting element may include two sub-light emitters EP31 and EP32 spaced apart from each other in a second direction DR2. However, this is an illustrated example, and the third light emitter EP3 may be provided as one pattern having a shape of a single body like the other light emitters EP1 and EP2, or at least one of the other light emitters EP1 and EP2 may include sub-light emitters, but is not limited to any one embodiment.

In an embodiment, the light emitters of the first row Rk may be composed of light emitters in the form in which the first-row first-column light emitting unit UT11 and the first-row second-column light emitting unit UT12 may be repeatedly arranged or disposed. The light emitters of the second row Rk+1 may be composed of light emitters in which the light emitters of the first row Rk have shapes and arrangements line-symmetrical with respect to an axis parallel to the first direction DR1. Accordingly, shapes and arrangement forms in which the light emitters constituting the first-row first-column light emitting unit UT11 and the first-row second-column light emitting unit UT12 and connected portions of the connection wirings are line-symmetrical with respect to an axis parallel to the first direction DR1 may correspond to those of light emitters constituting the second-row first-column light emitting unit UT21 and the second-row second-column light emitting unit UT22 and connected portions of connection wirings.

Hereinafter, the first-row first-column light emitting unit UT11 will be described. For ease of description, FIG. 4B illustrates second electrodes EL2_1, EL2_2, and EL2_3, pixel drivers PDC, and connection wirings CN. The second electrodes EL2_1, EL2_2, and EL2_3 may be distinguished by the separator SPR. In an embodiment, one light emitting unit UT may include three light emitters EP1, EP2, and EP3. Accordingly, the light emitting unit UT may include three second electrodes EL2_1, EL2_2, and EL2_3 (hereinafter, first to third cathodes), three pixel drivers PDC1a, PDC1b, PDC2a, PDC2b, PDC3a and PDC3b, and three connection wirings CN1, CN2, and CN3. However, this is an illustrated example, and the number and arrangement of the light emitting unit UT may be designed in various ways, and are not limited to any one embodiment. FIG. 4B may further include light emitting connected portions CE1a, CE1b, CE2a, CE2b, CE3a and CE3b. It is also noted that FIG. 4B may also further include driving connection portions CD1a, CD1b, CD2a, CD2b, CD3a, and CD3b. FIG. 4B may also include EL2_1a, EL2_1b, EL2_2a, EL2_2b, EL2_3a and EL2_3b.

The first to third pixel drivers PDC1a, PDC1b, PDC2a, PDC2b, PDC3a and PDC3b are connected to light emitting elements constituting the first to third light emitters EP1, EP2, and EP3, respectively. In the disclosure, "connected" may include not only a case of being connected by direct physical contact, but also a case of being electrically connected.

The first to third pixel drivers PDC1a, PDC1b, PDC2a, PDC2b, PDC3a and PDC3b may be sequentially disposed along the first direction DR1. Disposition positions of the first to third pixel drivers PDC1a, PDC1b, PDC2a, PDC2b, PDC3a and PDC3b may be designed independently of positions or shapes of the first to third light emitters EP1, EP2, and EP3.

For example, the first to third pixel drivers PDC1a, PDC1b, PDC2a, PDC2b, PDC3a and PDC3b may be disposed in a region partitioned by the separator SPR, for example, may be disposed at positions different from positions at which the first to third cathodes EL2_1, EL2_2, and EL2_3 are disposed, or may be designed to have an area of a shape different from the shape of the first to third cathodes EL2_1, EL2_2, and EL2_3. By way of example, the first to third pixel drivers PDC1a, PDC1b, PDC2a, PDC2b, PDC3a and PDC3b may be disposed to respectively overlap positions at which the first to third light emitters EP1, EP2, and EP3 are present and be disposed in a region partitioned by the separator SPR, for example, may be designed in a shape having an area similar to that of the first to third cathodes EL2_1, EL2_2, and EL2_3.

In an embodiment, each of the first to third pixel drivers PDC1a, PDC1b, PDC2a, PDC2b, PDC3a and PDC3b is illustrated in a rectangular shape, and each of the first to third light emitters EP1, EP2, and EP3 is arranged or disposed in a different form with a smaller area, and the first to third cathodes EL2_1, EL2_2, and EL2_3 are disposed at positions overlapping the first to third light emitters EP1, EP2, and EP3 but are illustrated in atypical shapes.

Accordingly, as illustrated in FIG. 4B, the first pixel driver PDC1a or PDC1b may be disposed at a position partially overlapping the first light emitter EP1, the second light emitter EP2, and another adjacent light emitting unit. The second pixel driver PDC2a or PDC2b may be disposed at a position overlapping the first light emitter EP1, the second light emitter EP2, and the third light emitter EP3. The third pixel driver PDC3a or PDC3b may be disposed at a position overlapping the third light emitter EP3. This is illustrated as an example, and the positions of the first to third pixel drivers PDC1a, PDC1b, PDC2a, PDC2b, PDC3a and PDC3b may be designed in various forms and arrangements independently of the light emitters EP1, EP2, and EP3, and are not limited to any one embodiment.

The connection wiring CN may be provided in plurality and disposed spaced apart from each other. The connection wiring CN may connect the pixel driver PDC and the light emitting element LD (see FIG. 5). By way of example, the connection wiring CN may correspond to a node (N4 of FIG. 2A or N3 of FIG. 2B) at which the light emitting element LD is connected to the pixel drivers PDC.

The connection wiring CN may include a first connected portion CE (hereinafter, a light emitting connected portion) and a second connected portion CD (hereinafter, a driving connected portion). The light emitting connected portion CE is provided on one side or a side of the connection wiring CN, and the driving connected portion CD may be provided on the other side of the connection wiring CN.

The driving connected portion CD may be a portion of the connection wiring CN that is connected to the pixel driver PDC. In an embodiment, the driving connected portion CD may be connected to one electrode of a transistor constituting the pixel driver PDC. By way of example, the driving connected portion CD may be connected to a drain of the sixth transistor T6 illustrated in FIG. 2A or the drain of the first transistor T1 illustrated in FIG. 2B. Accordingly, the position of the driving connected portion CD may correspond to the position of a transistor TR (see FIG. 5) physically connected to the connection wiring CN of the pixel driver. The light emitting connected portion CE may be a portion of the connection wiring CN that is connected to a light emitting element. In an embodiment, the light emitting connected portion CE may be connected to the second electrode EL2 (hereinafter, a cathode, see FIG. 5) of the light emitting element.

The light emitting unit UT may include first to third connection wirings CN1, CN2, and CN3. The first connection wiring CN1 may connect a light emitting element forming the first light emitter EP1 and the first pixel driver PDC1a or PDC1b, the second connection wiring CN2 may connect a light emitting element forming the second light emitter EP2 and the second pixel driver PDC2a or PDC2b, and the third connection wiring CN3 may connect a light emitting element forming the third light emitter EP3 and the third pixel driver PDC3a or PDC3b.

By way of example, the first to third connection wirings CN1, CN2, and CN3 may connect the first to third cathodes EL2_1, EL2_2, and EL2_3, and the first to third pixel drivers PDC1a, PDC1b, PDC2a, PDC2b, PDC3a and PDC3b, respectively. The first connection wiring CN1 may include a first driving connected portion CD1 connected to the first pixel driver PDC1a or PDC1b and a first light emitting connected portion CE1 connected to the first cathode EL2_1. The second connection wiring CN2 may include a second driving connected portion CD2 connected to the second pixel driver PDC2a or PDC2b and a second light emitting connected portion CE2 connected to the second cathode EL2_2. The third connection wiring CN3 may include a third driving connected portion CD3 connected to the third pixel driver PDC3a or PDC3b and a third light emitting connected portion CE3 connected to the third cathode EL2_3.

The first to third driving connected portions CD1, CD2, and CD3 may be arranged or disposed along the first direction DR1. As described above, the first to third driving connected portions CD1, CD2, and CD3 may correspond to positions of connection transistors constituting the first to third pixel drivers PDC1a, PDC1b, PDC2a, PDC2b, PDC3a and PDC3b, respectively. In one pixel, a connection transistor may be a transistor including, as one electrode, a connection node to which a pixel driver and a light emitting element are connected, and may correspond to, for example, the sixth transistor T6 of FIG. 2A or the first transistor T1 of FIG. 2B. According to the disclosure, by designing a pixel driver identically for all pixels regardless of the shape, size, and light emitting color of a light emitter, it is possible to simplify processes and reduce costs.

In an embodiment, the first to third light emitting connected portions CE1, CE2, and CE3 may be defined at positioned not overlapping the light emitters EP1, EP2, and EP3 on a pane. As described above, each of the light emitting connected portions CE1, CE2, and CE3 may be provided at a position not overlapping the light emitting opening OP-PDL (see FIG. 5), since the light emitting connected portion CE (see FIG. 5) of the connection wiring CN is a portion to which the light emitting element LD (see FIG. 5) is connected and a portion in which a second tip portion TP2 (see FIG. 5) is defined. For example, in each of the cathodes EL2_1, EL2_2, and EL2_3, the light emitting connected portions CE1, CE2, and CE3 may be disposed at positions spaced apart from the light emitters EP1, EP2, and EP3, and the cathodes EL2_1, EL2_2, and EL2_3 may include some or a number of regions protruding from the light emitters EP1, EP2, and EP3 on a plane in order to be connected to the connection wirings CN1, CN2, and CN3 at the positions at which the light emitting connected portions CE1, CE2, and CE3 are disposed.

For example, the first cathode EL2_1 may include a protruding portion in a shape protruding from the first light emitter EP1 at a position not overlapping the first light emitter EP1 in order to be connected to the first connection wiring CN1 at a position at which the first light emitting connected portion CE1 is disposed, and the light emitting connected portion CE1 may be provided in the protruding portion. Accordingly, the first light emitting connected portion CE1 which may be connected to the first connection wiring CN1 without reducing the light emitting area of the first light emitter EP1 may be provided.

As described above, the connection wiring CN may include the light emitting connected portion CE and the driving connected portion CD. The first pixel driver PDC1a or PDC1b, for example, the first driving connected portion CD1 which is the position of the transistor TR, may be defined at a position not overlapping the first light emitter EP1 on a plane. According to an embodiment, since the first connection wiring CN1 is disposed in the first light emitter EP1, the first cathode EL2_1 and the first pixel driver PDC1a or PDC1b spaced apart from each other may be readily connected.

The third pixel driver PDC3, for example, the third driving connected portion CD3, which is a position connected to the transistor TR, may be defined at a position not overlapping the third light emitter CE3 on a plane and may be disposed at a position overlapping the third light emitter EP3. According to an embodiment, since the third cathode EL2_3 and the pixel driver PDC3 are connected through the third connection wiring CN3, even in case that the position of the third driving connected portion CD3 overlaps the third light emitter EP3 on a plane, the connection between the third pixel driver PDC3 and the third cathode EL2_3 may be facilitated. Accordingly, restrictions according to the position or shape of the third light emitter EP3 in the design of the pixel driver PDC3 may be reduced, and the degree of freedom in circuit design may be improved.

Referring back to FIG. 4A, the light emitters of the second row Rk+1 may be composed of light emitters in which the first-row light emitting units UT11 and UT12 have shapes and arrangements line-symmetrical with respect to an axis parallel to the first direction DR1. At this time, due to the relationship between the first-row light emitting units UT11 and UT12, the second-row light emitting units UT21 and UT22 may substantially be composed of emitters in a form in which the first-row light emitting units UT11 and UT12 are shifted in the first direction DR1. For example, the second-row first-column light emitting unit UT21 may be composed of light emitters having the same shape as that of the first-row second-column light emitting unit UT12, and the second-row second-column light emitting unit UT22 may be composed of light emitters having the same shape as that of the first-row first-column light emitting unit UT11.

Accordingly, the shape and arrangement form of connection wirings CN-c connected to the second-row first-column light emitting unit UT21 may be the same as those of connection wirings CN1b, CN2b, and CN3b connected to the first-row second-column light emitting unit UT12. In the same manner, the shape and arrangement form of connection wirings CN-d disposed in the second-row second-column light emitting unit UT22 may be the same as those of connection wirings CN1a, CN2a, and CN3a connected to the first-row first-column light emitting unit UT11.

Referring to FIG. 4C, the first electrode EL1 (hereinafter, an anode) of a light emitting element according to an embodiment may be commonly provided to the light emitters EP1, EP2, and EP3. For example, the anode EL1 may be provided in a shape of a single body and be disposed overlapping light emitters or the separator SPR. As described above, the first driving voltage VDD (see FIG. 1) may be applied to the anode EL1 and a common voltage may be provided to all of the light emitters. The anode EL1 may be connected to the first driving voltage line VDL (see FIG. 2A) providing the first driving voltage VDD in the peripheral region NDA (see FIG. 3A or FIG. 3B), or may be connected to the first driving voltage line VDL in the display region DA, but is not limited to any one embodiment.

Openings OP-EL1 may be defined in the anode EL1 according to an embodiment, and the openings OP-EL1 may pass through the anode EL. The openings OP-EL1 may be disposed at positions not overlapping light emitters, and may generally be defined at positions overlapping the separator SPR. The openings OP-EL1 may facilitate discharge of a gas generated from an organic layer disposed on a lower side of the anode EL1, for example, a sixth insulation layer 60 (see FIG. 5) to be described later. Accordingly, in the process of manufacturing the display panel DP, the gas of the organic layer may be sufficiently discharged, and thereafter, the problem of deterioration of the light emitting element LD caused by the gas discharged from the organic layer may be solved.

According to the disclosure, unlike light emitters in which a connection transistor and a cathode of a corresponding pixel driver overlap on a plane, light emitters including a cathode having a shape not overlapping a connection transistor of a pixel driver further include a connection wiring, and thus, may be readily connected to the pixel driver. According to the disclosure, by further including a connection wiring, a light emitting element may be stably connected to a pixel driver by changing only the shape of a cathode without changing the design of light emitters. Accordingly, the influence of arrangement or shape of light emitters on the connection with the pixel driver may be reduced, so that the degree of freedom in designing the disposition of the pixel driver may be improved and the degradation in the aperture ratio of a light emitter may be prevented.

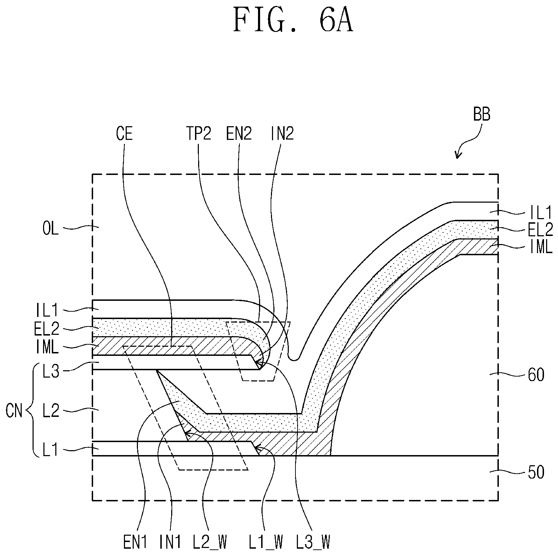

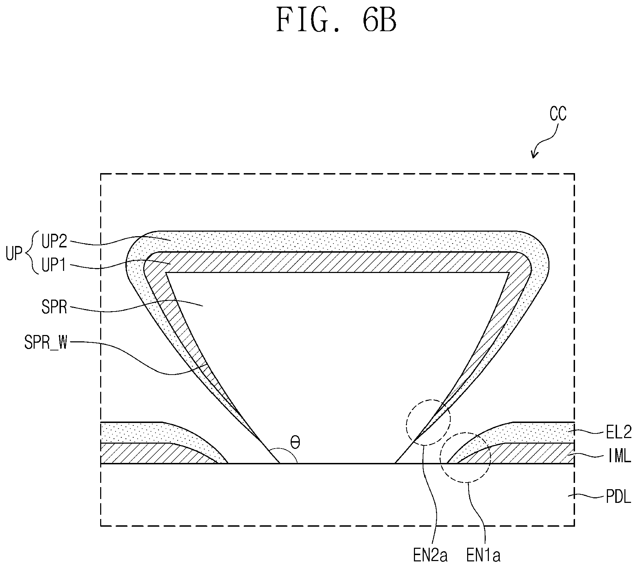

FIG. 5 is a schematic cross-sectional view of a display panel according to an embodiment. FIG. 6A is a schematic cross-sectional view showing region BB illustrated in FIG. 5. FIG. 6B is a schematic cross-sectional view showing region CC illustrated in FIG. 5.

FIG. 5 illustrates a schematic cross-sectional view showing a portion corresponding to line I-I' of FIG. 4B. Hereinafter, with reference to FIG. 5 to FIG. 6B, the disclosure will be described.

Referring to FIG. 5, the display panel DP of an embodiment may include a base layer BS, a driving element layer DDL, the sixth insulation layer 60, a light emitting element layer LDL, and a sensor layer ISL. The driving element layer DDL may include insulation layers 10, 20, 30, 40, and 50 disposed on the base layer BS, and conductive patterns and semiconductor patterns disposed between the insulation layers. The conductive patterns and the semiconductor patterns may be disposed between the insulation layers and constitute the pixel driver PDC and the connection wiring CN. In FIG. 5, for ease of description, a cross-section of one region of among regions in which one light emitter is disposed is illustrated.

The base layer BS may be a member which provides a base surface on which the pixel driver PDC is disposed. The base layer BS may be a rigid substrate, or a flexible substrate capable of bending, folding, rolling, and the like within the scope of the claims. The base layer BS may be a glass substrate, a metal substrate, a polymer substrate, or the like within the scope of the claims. However, an embodiment is not limited thereto, and the base layer BS may be an inorganic layer, an organic layer, or a composite material layer.

The base layer BS may have a multi-layered structure. The base layer BS may include a first polymer resin layer, a silicon oxide(SiOₓ) layer disposed on the first polymer resin layer, an amorphous silicon(a-Si) layer disposed on the silicon oxide layer, and a second polymer resin layer disposed on the amorphous silicon layer. The silicon oxide layer and the amorphous silicon layer may be referred to as a base barrier layer.

The polymer resin layer may include a polyimide-based resin. The polymer resin layer may include at least one of an acrylate-based resin, a methacrylate-based resin, a polyisoprene-based resin, a vinyl-based resin, an epoxy-based resin, a urethane-based resin, a cellulose-based resin, a siloxane-based resin, a polyamide-based resin, or a perylene-based resin. In the disclosure, "XXX-based" resin means that a functional group of "XXX" is included.

Each of insulation layers, conductive layers, and semiconductor layers disposed on the base layer BS of the display panel DP may be formed by coating, deposition, or the like within the scope of the claims. Thereafter, an organic layer, an inorganic layer, a semiconductor layer, and a conductive layer may be selectively patterned through performing a photolithography process a number of times to form a hole in the insulation layer, or to form a semiconductor pattern, a conductive pattern, a signal line, and the like within the scope of the claims.

The driving element layer DDL may include first to fifth insulation layers 10, 20, 30, 40, and 50 and the pixel driver PDC sequentially laminated on the base layer BS. FIG. 5 illustrates one transistor TR and two capacitors C1 and C2 in the pixel driver PDC. The transistor TR may correspond to a transistor connected to the light emitting element LD through a connection wiring CN, for example, a connection transistor connected to a node (the fourth node N4 of FIG. 2A, or the second node N2 of FIG. 2B) corresponding to the cathode of the light emitting element LD, and by way of example, may correspond to the sixth transistor T6 of FIG. 2A or the first transistor T1 of FIG. 2B. Although not illustrated, other transistors constituting the pixel driver PDC may have a structure the same as the structure of the transistor TR (hereinafter, a connection transistor) illustrated in FIG. 5. However, this is a described example, and the other transistors constituting the pixel driver PDC may have a structure different from the structure of the transistor TR, and are not limited to any one embodiment.

The first insulation layer 10 may be disposed on the base layer BS. The first insulation layer 10 may be an inorganic layer and/or an organic layer, and may have a single-layered or multi-layered structure. The first insulation layer 10 may include at least one of an aluminum oxide, a titanium oxide, a silicon oxide, a silicon nitride, a silicon oxynitride, a zirconium oxide, or a hafnium oxide. In an embodiment, the first insulation layer 10 is illustrated as a single-layered silicon oxide layer. Insulation layers to be described later may be inorganic layers and/or organic layers, and may have a single-layered structure or a multi-layered structure. The inorganic layer may include at least one of the above-described materials, but is not limited thereto.

The first insulation layer 10 may cover a lower conductive layer BCL. For example, the display panel DP may further include the lower conductive layer BCL disposed overlapping the connection transistor TR in a lower portion of the connection transistor TR. The lower conductive layer BCL may block an electric potential due to polarization of the base layer BS from affecting the connection transistor TR. The lower conductive layer BCL may block light incident to the connection transistor TR from a lower portion of the lower conductive layer BCL. Between the lower conductive layer BCL and the base layer BS, at least one of an inorganic barrier layer and a buffer layer may be further disposed.

The lower conductive layer BCL may include a reflective metal. For example, the lower conductive layer BCL may include titanium (Ti), molybdenum (Mo), an alloy containing molybdenum, aluminum (Al), an alloy containing aluminum, an aluminum nitride (AIN), tungsten (W), a tungsten nitride (WN), copper (Cu), or the like within the scope of the claims.

In an embodiment, the lower conductive layer BCL may be connected to a source of the transistor TR through a source electrode pattern W1. The lower conductive layer BCL may be synchronized with the source of the transistor TR. However, this is illustrated as an example, and the lower conductive layer BCL may be connected to a gate of the transistor TR, thereby being synchronized with the gate. By way of example, the lower conductive layer BCL may be connected to another electrode and be independently applied with a constant voltage or a pulse signal. The lower conductive layer BCL may be provided in an isolated form from another conductive pattern. At this time, the source electrode pattern W1 and the like may be omitted. The lower conductive layer BCL according to an embodiment may be provided in various embodiments, and is not limited to any one embodiment.

The connection transistor TR is disposed on the first insulation layer 10. The connection transistor TR may include a semiconductor pattern SP and a gate electrode GE. The semiconductor pattern SP may be disposed on the first insulation layer 10. The semiconductor pattern SP may include an oxide semiconductor. For example, the oxide semiconductor may include a transparent conductive oxide (TCO) such as an indium tin oxide (ITO), an indium zinc oxide (IZO), an indium gallium zinc oxide (IGZO), a zinc oxide (ZnO), an indium oxide (In₂O₃), or the like within the scope of the claims. However, an embodiment disclosure is not limited thereto, and the semiconductor pattern may include amorphous silicon, low-temperature polycrystalline silicon, or polycrystalline silicon.

The second insulation layer 20 commonly overlaps pixels, and may cover the semiconductor pattern SP. The second insulation layer 20 may be an inorganic layer and/or an organic layer, and may have a single-layered or a multi-layered structure. The second insulation layer 20 may include at least one of an aluminum oxide, a titanium oxide, a silicon oxide, a silicon nitride, a silicon oxynitride, a zirconium oxide, or a hafnium oxide. In an embodiment, the second insulation layer 20 may be a single-layered silicon oxide layer.

The semiconductor pattern SP may include the source region SR, a drain region DR, and an active region CR (or a channel region) which are divided according to the degree of conductivity. The channel region CR may be a portion overlapping the gate electrode GE on a plane. The source region SR and the drain region DR may be portions spaced apart from each other with the channel region CR interposed therebetween. In case that the semiconductor pattern SP is an oxide semiconductor, the source region SR and the drain region DR may each be a reduced region. Accordingly, the source region SR and the drain region DR have a relatively high reduced metal content ratio compared to that of the active region CR. By way of example, in case that the semiconductor pattern SP is polycrystalline silicon, the source region SR and the drain region DR may each be a region doped to a high concentration.

The source region SR and the drain region DR may have relatively high conductivity compared to that of the channel region CR. The source region SR may correspond to a source electrode of the connection transistor TR, and the drain region DR may correspond to a drain electrode of the connection transistor TR. As illustrated in FIG. 5, in the connection transistor TR, a separate source electrode pattern and a separate drain electrode pattern respectively connected to the source region SR and the drain region DR may be further provided. By way of example, the separate source electrode pattern and the separate drain electrode pattern may each be formed as a single body with one of lines constituting the pixel driver PDC, and are not limited to any one embodiment.

The gate electrode GE is disposed on the second insulation layer 20. The gate electrode GE may correspond to the gate of the connection transistor TR.

The gate electrode GE may be disposed on the semiconductor pattern SP. However, this is only an illustrated example, and the gate electrode GE may be disposed on a lower side of the semiconductor pattern DP, and is not limited to any one embodiment.

The gate electrode GE may include titanium (Ti), silver (Ag), molybdenum (Mo), aluminum (Al), an aluminum nitride, tungsten (W), a tungsten nitride (WN), copper (Cu), an alloy thereof, or the like, but is not limited thereto.

A first capacitor electrode CPE1 and a second capacitor electrode CPE2 among conductive patterns W1, W2, CPE1, CPE2, and CPE3 constitute a first capacitor C1. The first capacitor electrode CPE1 and the second capacitor electrode CPE2 may be spaced apart from each other with the first insulation layer 10 and the second insulation layer 20 interposed therebetween.

In an embodiment, the first capacitor electrode CPE1 and the lower conductive layer BCL may have a shape of a single body. The second capacitor electrode CPE2 and the gate electrode GE may have a shape of a single body.

On the third insulation layer 30, a third capacitor electrode CPE3 may be disposed. The third capacitor electrode CPE3 may be spaced apart from the second capacitor electrode CPE2 with the third insulation layer 30 interposed therebetween, and may overlap the same. The third capacitor electrode CPE3 and the second capacitor electrode CPE2 may constitute a second capacitor C2.

On the third capacitor electrode CPE3, the fourth insulation layer 40 may be disposed.

On the fourth insulation layer 40, a source electrode pattern W1 and a drain electrode pattern W2 may be disposed. The source electrode pattern W1 may be connected to a source region SR of the connection transistor TR through a first contact-hole CNT1, and the source electrode pattern W1 and the source region SR of the semiconductor pattern SP may function as a source of the connection transistor TR. The drain electrode pattern W2 may be connected to a drain region DR of the connection transistor TR through a second contact-hole CNT2, and the drain electrode pattern W2 and the drain region DR of the semiconductor pattern SP may function as a drain of the connection transistor TR.

On the source electrode pattern W1 and the drain electrode pattern W2, the fifth insulation layer 50 may be disposed.

On the fifth insulation layer 50, the connection wiring CN is disposed. The connection wiring CN connects the connection transistor TR and the light emitting element LD. The connection wiring CN may be a connection node for connecting the pixel driver PDC and the light emitting element LD. For example, the connection wiring CN may correspond to the fourth node N4 illustrated in FIG. 2A, or may correspond to the second node N2 illustrated in FIG. 2B. This is described as an example, and as long as the connection wiring CN can be connected to the light emitting element LD, the connection wiring CN may be defined as a connection node connected with various elements among elements constituting the pixel driver PDC according to a design of the pixel driver PDC, and is not limited to any one embodiment.

The sixth insulation layer 60 may be disposed between the driving element layer DDL and the light emitting element layer LDL. The sixth insulation layer 60 is disposed on the fifth insulation layer 50 and covers the connection wiring CN. The fifth insulation layer 50 and the sixth insulation layer 60 may each be an organic layer. For example, the fifth insulation layer 50 and the sixth insulation layer 60 may each include a general purpose polymer such as benzocyclobutene (BCB), polyimide, hexamethyldisiloxane (HMDSO), polymethylmethacrylate (PMMA) and polystyrene (PS), a polymer derivative having a phenolic group, an acrylic polymer, an imide-based polymer, an aryl ether-based polymer, an amide-based polymer, a fluorine-based polymer, a p-xylene-based polymer, a vinyl alcohol-based polymer, a blend thereof, or the like within the scope of the claims.

The sixth insulation layer 60 may be provided with a through-hole which exposes at least a portion of the connection wiring CN. The connection wiring CN may be electrically connected to the light emitting element LD of the light emitting element layer LDL through the portion exposed from the sixth insulation layer 60. For example, the connection wiring CN connects the connection transistor TR and the light emitting element LD. A detailed description thereof will be described later.

On the sixth insulation layer 60, the light emitting element layer LDL is disposed. The light emitting element layer LDL may include a pixel definition film PDL, a light emitting element LD, an encapsulation layer ECL, and a separator SPR. In the display panel DP according to an embodiment, the sixth insulation layer 60 may be omitted, or be provided in plurality, and is not limited to any one embodiment.

The pixel definition film PDL may be an organic layer. For example, the pixel definition film PDL may include a general purpose polymer such as benzocyclobutene (BCB), polyimide, hexamethyldisiloxane (HMDSO), polymethylmethacrylate (PMMA) and polystyrene (PS), a polymer derivative having a phenolic group, an acrylic polymer, an imide-based polymer, an aryl ether-based polymer, an amide-based polymer, a fluorine-based polymer, a p-xylene-based polymer, a vinyl alcohol-based polymer, a blend thereof, or the like within the scope of the claims.

In an embodiment, the pixel definition film PDL may have properties of absorbing light, and for example, the pixel definition film PDL may have a black color. The pixel definition film PDL may include a black coloring agent. The black coloring agent may include a black dye and a black pigment. The black coloring agent may include carbon black, or a metal such as chromium or an oxide thereof. The pixel definition film PDL may correspond to a light blocking pattern having light blocking properties.

On the pixel definition film PDL, the opening OP-PDL (hereinafter, a light emitting opening) passing therethrough may be defined. The light emitting opening OP-PDL may be provided in plurality and be disposed corresponding to each light emitting element LD. The light emitting opening OP-PDL may be a region in which all constituent elements of the light emitting element LD overlap, and may be substantially a region in which light emitted by the light emitting element LD is displayed. Accordingly, the shape of the above-described light emitter EP (see FIG. 3A) may substantially correspond to the shape of the light emitting opening OP-PDL on a plane.

The light emitting element LD may include an organic light emission material, an inorganic light emission material, an organic-inorganic light emission material, a quantum dot, a quantum rod, a micro-LED, or a nano-LED.

The light emitting element LD may include the first electrode EL1, a middle layer IML, and the second electrode EL2. The first electrode EL1 may be a transflective, transmissive, or reflective electrode. According to an embodiment, the first electrode EL1 may include a reflective layer formed of silver (Ag), magnesium (Mg), aluminum (Al), platinum (Pt), palladium (Pd), gold (Au), nickel (Ni), neodymium (Nd), iridium (Ir), chromium (Cr), a compound thereof, or the like, and a transparent or translucent electrode layer formed on the reflective layer. The transparent or translucent electrode layer may be provided with at least one selected from the group consisting of an indium tin oxide (ITO), an indium zinc oxide (IZO), an indium gallium zinc oxide (IGZO), a zinc oxide (ZnO), or an indium oxide (In₂O₃), and an aluminum-doped zinc oxide (AZO). For example, the first electrode EL1 may include a laminated structure of ITO/Ag/ITO.

In an embodiment, the first electrode EL1 may be the anode of the light emitting element LD. For example, the first electrode EL1 may be connected to the first power line VDL (see FIG. 2A) and may receive the first power voltage VDD (see FIG. 2A). The first electrode EL1 may be connected to the first power line VDL in the display region DA, or may be connected to the first power line VDL in the peripheral region NDA. In the latter case, the first power line VDL may be disposed in the peripheral region NDA, and the first electrode EL1 may have a shape extended to the peripheral region NDA.

In an embodiment, the first electrode EL1 is illustrated as overlapping the light emitting opening OP-PDL and not overlapping the separator SPR, but an embodiment is not limited thereto. As described above, the first electrode of each pixel may have a shape of a single body, and as illustrated in FIG. 4C, may have a mesh or lattice shape in which openings are defined in some or a number of regions. For example, as long as the same first power voltage VDD can be applied to the first electrode EL1 of each of light emitting elements, the shape of the first electrode EL1 may be provided in various ways, and is not limited to any one embodiment.

The middle layer IML is disposed between the first electrode EL1 and the second electrode EL2. The middle layer IML may include a light emitting layer EML and a functional layer FNL. However, this is an illustrated example, and the light emitting element LD may include the middle layer IML of various structures, and is not limited to any one embodiment. For example, the functional layer FNL may be provided as layers, or may be provided as two or more layers spaced apart from each other with the light emitting layer EML interposed therebetween. By way of example, in an embodiment, the functional layer FNL may be omitted.

The light emitting layer EML may emit light by absorbing energy corresponding to a potential difference between the first electrode EL1 and the second electrode EL2. Although the light emitting layer EML is illustrated as an embodiment including an organic light emitting material, an embodiment is not limited thereto, and the light emitting layer EML may include an inorganic light emitting material or may be provided as a mixed layer of an organic light emitting material and an inorganic light emitting material.

The light emitting layer EML may be disposed overlapping the light emitting opening OP-PDL. In an embodiment, the light emitting layer EML may be divided and formed in each pixel. In case that the light emitting layer EML is divided and formed in each of the light emitters EP, the light emitting layer EML may emit light of at least any one color of blue, red, or green. However, an embodiment is not limited thereto, and the light emitting layer EML may have a shape of a single body commonly provided to adjacent light emitters EP. The light emitting layer EML may provide blue light, or may provide white light. The light emitting layer EML may have the same shape as that of the functional layer FNL, and may be provided as the middle layer IML having a shape of a single body without limitation on a layer boundary with the functional layer FNL.

The functional layer FNL is disposed between the first electrode EL1 and the second electrode EL2. By way of example, the functional layer FNL may be disposed between the first electrode EL1 and the light emitting layer EML, or be disposed between the second electrode EL2 and the light emitting layer EML. By way of example, the functional layer FNL may be disposed between the first electrode EL1 and the light emitting layer EML and between the second electrode EL2 and the light emitting layer EML. In an embodiment, the light emitting layer EML is illustrated as being inserted into the functional layer FNL. However, this is an illustrated example, and the functional layer FNL may include a layer disposed between the light emitting layer EML and the first electrode EL1, and/or a layer disposed between the light emitting layer EML and the second electrode EL2, and may be provided in plurality, but is not limited to any one embodiment.

The functional layer FNL may control the movement of charges. The functional layer FNL may include a hole injection/transport material and/or an electron injection/transport material. The functional layer FNL may include at least one of an electron blocking layer, a hole transport layer, a hole injection layer, a hole blocking layer, an electron transport layer, an electron injection layer, and a charge generation layer.

The second electrode EL2 may be disposed on the middle layer IML. As described above, the second electrode EL2 is connected to the pixel driver PDC through the connection node (the fourth node N4 of FIG. 2A or the second node N2 of FIG. 2B). In an embodiment, the second electrode EL2 may be electrically connected to the connection transistor TR through the connection wiring CN.

Referring to FIG. 5, the connection wiring CN may include the driving connected portion CD, the light emitting connected portion CE, and an extension portion CNL. Hereinafter, the connection wiring CN will be described with reference to FIG. 5 to FIG. 6B.

The driving connected portion CD may be a portion of the connection wiring CN that is connected to the pixel driver PDC, and may be a portion substantially connected to the connection transistor TR. In an embodiment, the driving connected portion CD passes through the fifth insulation layer 50 and is connected to the drain region DR of the semiconductor pattern SP through the drain electrode pattern W2 of the transistor TR.

The light emitting connected portion CE may be a portion of the connection wiring CN that is connected to the light emitting element LD. The light emitting connected portion CE may be defined in a region exposed from the sixth insulation layer 60, and may be a portion to which the second electrode EL2 is directly connected. At this time, the second tip portion TP2 may be defined in the light emitting connected portion CE.

Referring to FIG. 5 and FIG. 6A, the connection wiring CN may have a three-layered structure. By way of example, the connection wiring CN may include a first layer L1, a second layer L2, and a third layer L3 which are sequentially laminated along a third direction DR3. The first layer L1 may be relatively thinner than the second layer L2. For example, the first layer L1 may include titanium (Ti).

The second layer L2 may include a material different from that of the first layer L1. The second layer L2 may include a highly conductive material. For example, the second layer L2 may include aluminum (Al).

The second layer L2 may include a material having a higher etch selection ratio than the first layer L1. A second end L2_W of the second layer L2 may be defined further inside than a first end L1_W of the first layer L1. For example, the first end L1_W of the first layer L1 may protrude outward from the second end L2_W of the second layer L2.

The third layer L3 may include a material different from that of the second layer L2. The third layer L3 may include a material having a lower etch selection ratio than the second layer L2. For example, the third layer L3 may include titanium (Ti). A third end L3_W of the third layer L3 may protrude outward from the second end L2_W of the second layer L2. For example, the second end L2_W of the second layer L2 may be disposed further inside than the third end L3_W of the third layer L3 to have an undercut shape or an overhang structure. The second tip portion TP2 of the light emitting connected portion CE may be defined by a portion of the third layer L3 further protruding than the second layer L2.

The sixth insulation layer 60 and the pixel definition film PDL expose the second tip portion TP2. By way of example, a first opening OP1 for exposing one side or a side of the connection wiring CN in which the second tip portion TP2 is defined may be defined on the sixth insulation layer 60, and a second opening OP2 overlapping the first opening OP1 may be defined on the pixel definition film PDL. A planar area of the second opening OP2 may be at least the same as that of the first opening OP1, or may be greater than that of the first opening OP1.

The second electrode EL2 may also be formed on some or a number of regions of the sixth insulation layer 60 exposed by the second opening OP2. The second electrode EL2 may also be formed on an upper surface of the sixth insulation layer 60 and an upper surface of the second tip portion TP2 of the connection wiring CN exposed by the first opening OP1. At this time, the second electrode EL2 may include one end EN1 formed along the upper surface of the sixth insulation layer 60 and the other end EN2 formed on the upper surface of the second tip portion TP2. One end EN1 and the other end EN2 may be separated from each other in a region in which the light emitting connected portion CE is defined. For example, the second electrode EL2 may be disconnected by the second tip portion TP2, and accordingly, one end EN1 and the other end EN2 spaced apart from each other may be formed. One end EN1 is formed along the second end L2_W of the second layer L2 and comes in contact with the second end L2_W of the second layer L2, and is disposed on a lower side of the third layer L3. The other end EN2 is disconnected from an end of the third layer L3 and is not extended to the lower side of the third layer L3. In an embodiment, the other end EN2 is illustrated as covering the third end L3_W of the third layer L3, but this is an illustrated example, and at least a portion of the third end L3_W of the third layer L3 may be exposed from the other end EN2. According to the disclosure, the second tip portion TP2 formed on the connection wiring CN may cut the second electrode EL2 into two portions. One of the two cut portions comes in contact with the second layer L2 having a relatively high conductivity, and thus, may be electrically connected to the light emitting connected portion CE of the connection wiring CN.

The middle layer IML may also be cut into two portions IN1 and IN2 with respect to the second tip portion TP2. The middle layer IML may include one end IN1 formed along the upper surface of the sixth insulation layer 60 and the other end IN2 formed on the upper surface of the second tip portion TP2. One end IN1 and the other end IN2 of the middle layer IML may be separated from each other in a region in which the light emitting connected portion CE is defined.

Among disconnected portions of the middle layer IML, the end portion IN1 present on the side of one end or an end EN1 of the second electrode EL2 may cover the first layer L1 and contact with the second layer L2, and the end portion IN2 present on the side of the other end or another end EN2 of the second electrode EL2 may be formed on the other end or another end EN2 of the second electrode EL2. At this time, one end or an end EN1 of the second electrode EL2 has a relatively larger contact area with respect to the second end L2_W of the second layer L2 than the end portion IN1 of the middle layer IML present on the same side. A portion of the second end L2_W of the second layer L2 that is not covered by the middle layer IML may all be covered by the second electrode EL2. This reduces an area as much as possible in which the middle layer IML is in contact with the second end L2_W of the second layer L2 while being disconnected by the second tip portion TP2 through a difference in deposition angle to be described later, and may increase an area as much as possible in which the second electrode EL2 is in contact with the second end L2_W of the second layer L2. Therefore, in the light emitting connected portion CE, the degree of intervention of the middle layer IML may be reduced, and the connection between the second electrode EL2 and the second layer L2 may be facilitated. Therefore, the second electrode EL2 may be stably connected to the connection wiring CN while being separated for each pixel without a separate patterning process.

The connection wiring CN may include the light emitting connected portion CE, the driving connected portion CD, and the extension portion CNL. According to an embodiment, the light emitting connected portion CE, the extension portion CNL, and the driving connected portion CD may be disposed on the same layer. The driving connected portion CD may be a portion of the connection wiring CN that is connected to the pixel driver PDC, and may be a portion substantially connected to the connection transistor TR. In an embodiment, the driving connected portion CD passes through the fifth insulation layer 50 and is connected to the drain DE of the connection transistor TR through the drain electrode pattern W2. The light emitting connected portion CE may be a portion of the connection wiring CN that is connected to the light emitting element LD. The light emitting connected portion CE may be defined in a region exposed from the sixth insulation layer 60, and may be a portion to which the second electrode EL2 is directly connected.

The driving connected portion CD and the extension portion CNL may include a first tip portion TP1, and the light emitting connected portion CE may include the second tip portion TP2. Each of the second electrode EL2 and the functional layer FNL may be cut into two portions with respect to the second tip portion TP2. Hereinafter, details of the structure of the first tip portion TP1 and the second tip portion TP2 will be described later.

The display panel DP may include the separator SPR. The separator SPR may be disposed on the pixel definition film PDL. The second electrode EL2 and the middle layer IML may be commonly formed in the pixels by using an open mask. At this time, the second electrode EL2 and the middle layer IML may be partitioned by the separator SPR. As described above, the separator SPR may have a closed-line shape for each light emitter so as to be independent of each light emitter, and accordingly, the second electrode EL2 may have a shape divided for each light emitter. For example, the second electrode EL2 may be electrically independent of each adjacent pixel.

Referring to FIG. 5 and FIG. 6B, the separator SPR will be described in more detail. FIG. 6B is a schematic cross-sectional view of an enlarged separator SPR. The separator SPR may have a reverse tapered shape. For example, an inner angle θ (hereinafter, a taper angle) formed by an outer surface SPR_W of the separator SPR with respect to the upper surface the pixel definition film PDL may be an obtuse angle. However, this is an illustrated example, and as long as the separator SPR can disconnect a laminated layer such as the middle layer IML and the second electrode EL2, the taper angle θ may be set in various ways, and the separator SPR may have the same structure as that of the second tip portion TP2, and is not limited to any one embodiment.

The separator SPR may have insulation properties by including an organic material. By the separator SPR, the laminated layer, for example, the middle layer IML and the second electrode EL2 may be disconnected. The middle layer IML and the second electrode EL2 may be partitioned or separated by the separator SPR from a middle layer IML and a second electrode EL2 included in an adjacent light emitting element. A first end EN1a and a second end EN2a may be formed on the laminated layer by the separator SPR. The first end EN1a may be spaced apart from the separator SPR and be positioned on the pixel definition film PDL. The second end EN2a may be separated from the first end EN1a and cover at least a portion of the outer surface SPR_W of the separator SPR. In FIG. 6B, the first end EN1a is illustrated as being spaced apart at a selectable interval from the outer surface SPR_W of the separator SPR, but an embodiment is not limited thereto, and if separated from the second end EN2a, the first end EN1a may also contact the outer surface SPR_W of the separator SPR.

The first end EN1a and the second end EN2a may mean an electrical disconnection. For example, even in case that the first end EN1a and the second end EN2a are physically connected to each other without being formed on the laminated layer, if the second end EN2a formed along the outer surface SPR_W of the separator SPR is formed to be thin so that no electrical connection is made between a portion formed in the separator SPR and an adjacent portion, the laminated layer may be considered to be partitioned by the separator SPR.

In an upper portion the separator SPR, a dummy layer UP may be disposed. The dummy layer UP may include a first dummy layer UP1 disposed on the separator SPR and a second dummy layer UP2 disposed on the first dummy layer UP1. The first dummy layer UP1 and the middle layer IML may be formed through the same process, and the second dummy layer UP2 and the second electrode EL2 may be formed through the same process. For example, the first dummy layer UP1 and the second dummy layer UP2 may be formed in case that manufacturing the middle layer IML and the second electrode EL2. In an embodiment, the dummy layer UP may be omitted.

According to the disclosure, even if there is no separate patterning process through a mask, by preventing the second electrode EL2 or the middle layer IML from being formed on the outer surface SPR_W of the separator SPR or by forming the same thin in case that forming the second electrode EL2 and the middle layer IML, it is possible to allow the second electrode EL2 or the middle layer IML to be partitioned for each pixel. However, this is an illustrated example, and as long as the second electrode EL2 and the middle layer IML can be disconnected, the shape of the separator SPR may be changed in various ways, and is not limited to any one embodiment.

According to the disclosure, the display panel DP may include the connection wiring CN, so that the electrical connection between the second electrode EL2 and the connection transistor TR may be facilitated. According to the disclosure, by forming the second tip portion TP2 in the connection wiring CN, it is possible to readily partition the second electrode EL2 for each light emitter without a separate patterning process. Through the control of a deposition angle, it is possible to stably implement the electrical connection between the second electrode EL2 and the connection wiring CN. Therefore, even though the second electrode EL2 connected to the pixel driver PDC is disposed above the first electrode EL1, the display panel DP which may be stably connected to the pixel driver PDC may be readily implemented.

Referring back to FIG. 5, the encapsulation layer ECL may be disposed on the pixel definition film PDL to cover the separator SPR. The encapsulation layer ECL may include a first inorganic layer IL1, an organic layer OL, and a second inorganic layer IL2 which are sequentially laminated. However, an embodiment is not limited thereto, and the encapsulation layer ECL may further include inorganic layers and organic layers.

The first and the second inorganic layers IL1 and IL2 protect the light emitting element layer LDL from moisture and oxygen, and the organic layer OL protects the light emitting element layer LDL from foreign materials such as dust particles. The first and second inorganic layers IL1 and IL2 may include a silicon nitride layer, a silicon oxynitride layer, a silicon oxide layer, a titanium oxide layer, an aluminum oxide layer, or the like within the scope of the claims. The organic layer OL may include an acrylic organic layer, but is not limited thereto.

The sensing layer ISL senses an external input. In an embodiment, the sensing layer ISL may be formed on the light emitting element layer LDL through a continuous process. At this time, the sensing layer ISL may be expressed as being directly disposed on the light emitting element layer LDL. Being directly disposed may mean that there are no other components disposed between the sensing layer ISL and the light emitting element layer LDL. For example, a separate adhesive member may not be disposed between the sensing layer ISL and the light emitting element layer LDL. However, this is an illustrated example, and in the display panel DP according to an embodiment disclosure, the sensing layer ISL may be divided and formed and provided, or may be coupled or connected to the light emitting element layer LDL through an adhesive member, but is not limited to any one embodiment.

The sensing layer ISL may include conductive layers MTL1 and MTL2 and insulation layers 71, 72 and 73. The insulation layers 71, 72, and 73 may include first to third sensing insulation layers 71, 72, and 73. However, this is an illustrated example, and the number of insulation layers constituting the insulation layers 71, 72, and 73 are not limited to any one embodiment.

The first sensing insulation layer 71 may be an inorganic layer including at least one of a silicon nitride, a silicon oxynitride, or a silicon oxide. By way of example, the first sensing insulation layer 71 may be an organic layer including an epoxy resin, an acrylic resin, or an imide-based resin. The first sensing insulation layer 71 may have a single-layered structure, or a multi-layered structure in which layers are laminated along the third direction DR3.

The conductive layers MTL1 and MTL2 may include a first conductive layer MTL1 and a second conductive layer MTL2. The first conductive layer MTL1 may be disposed between the first sensing insulation layer 71 and the second sensing insulation layer 72, and the second conductive layer MTL2 may be disposed between the second sensing insulation layer 72 and the third sensing insulation layer 73. A portion of the second conductive layer MTL2 may be connected to the first conductive layer MTL1 through a contact-hole CNT formed on the second sensing insulation layer 72. Each of the conductive layers MTL1 and MTL2 may have a single-layered structure, or a multi-layered structure laminated along the third direction DR3.

A conductive layer of a single-layered structure may include a metal layer or a transparent conductive layer. The metal layer may include molybdenum, silver, titanium, copper, aluminum, or an alloy thereof. The transparent conductive layer may include a transparent conductive oxide such as indium tin oxide (ITO), indium zinc oxide (IZO), zinc oxide (ZnO), indium tin zinc oxide (ITZO), or the like within the scope of the claims. The transparent conductive layer may include a conductive polymer such as PEDOT, a metal nanowire, graphene, and the like within the scope of the claims.

A conductive layer of a multi-layered structure may include metal layers. The metal layers may have, for example, a three-layered structure of titanium/aluminum/titanium. The conductive layer of a multi-layered structure may include at least one metal layer and at least one transparent conductive layer.

The first conductive layer MTL1 and the second conductive layer MTL2 may constitute a sensor configured to sense an external input in the sensing layer ISL. The sensor may be driven by a capacitive method and may be driven in either a mutual-cap capacitive method or a self-cap capacitive method. However, this is described as an example, and the sensor may be driven by a resistive film method, an ultrasonic method, or an infrared method in addition to the capacitive method, and is not limited to any one embodiment.

Each of the first conductive layer MTL1 and the second conductive layer MTL2 may include a transparent conductive oxide, or may have a metal mesh shape formed of an opaque conductive material. The first conductive layer MTL1 and the second conductive layer MTL2 may have various materials and various shapes as long as the visibility of an image displayed by light generated by a light emitting element layer LDL is not degraded, and are not limited to any one embodiment.

The third sensing insulation layer 73 may include an inorganic film. The inorganic film may include at least one of an aluminum oxide, a titanium oxide, a silicon oxide, a silicon nitride, a silicon oxynitride, a zirconium oxide, or a hafnium oxide.

By way of example, the third sensing insulation layer 73 may include an organic film. The organic film may include at least any one among an acrylic resin, a methacrylic resin, polyisoprene, a vinyl-based resin, an epoxy-based resin, a urethane-based resin, a cellulose-based resin, a siloxane-based resin, a polyimide-based resin, a polyamide-based resin, or a perylene-based resin.

According to the disclosure, the display panel DP may include the light emitting connected portion CE and the driving connected portion CD spaced apart from each other, so that the position of the light emitting element LD may be designed at various positions without being limited to the configuration of the pixel driver PDC or the position of the connection transistor TR. For example, the degree of freedom in designing the position of the light emitting element LD or designing the pixel driver PDC may be increased. According to the disclosure, the display panel DP may include the connection wiring CN, so that the electrical connection between the second electrode EL2 disposed above the first electrode EL1 serving as an anode and the pixel driver PDC may be facilitated. According to the disclosure, by forming a tip portion in the connection wiring CN, it is possible to readily disconnect an organic layer such as the middle layer IML without a separate patterning process. Through the control of a deposition angle, it is possible to readily implement the electrical connection between the second electrode EL2 and the connection wiring CN.

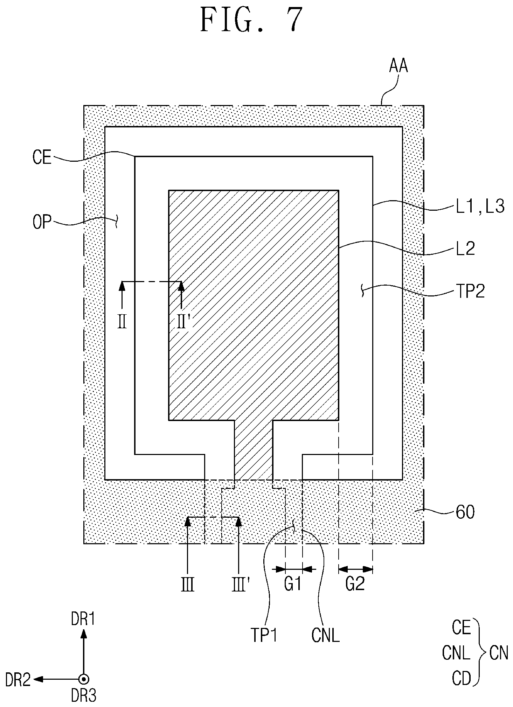

FIG. 7 is a schematic plan view showing region AA illustrated in FIG. 4A.

Referring to FIG. 5 and FIG. 7, the connection wiring CN may include the light emitting connected portion CE connected to the second electrode EL2, the driving connected portion CD connected to the connection transistor TR, and the extension portion CNL extended from the driving connected portion CD and the light emitting connected portion CE and connecting the light emitting connected portion CE and the driving connected portion CD. The second electrode EL2 and the connection transistor TR may be electrically connected to each other through the light emitting connected portion CE, the driving connected portion CD, and the extension portion CNL. Each of the light emitting connected portion CE, the driving connected portion CD, and the extension portion CNL may include a first layer L1, a second layer L2, and a third layer L3.

The extension portion CNL may include the first tip portion TP1, and the light emitting connected portion CE may include the second tip portion TP2. The first tip portion TP1 may be defined as a portion in which the third end L3_W of the third layer L3 protrudes further outward than the second end L2_W of the second layer L2 in the extended portion CNL. The second tip portion TP2 may be defined as a portion in which the third end L3_W of the third layer L3 protrudes further outward than the second end L2_W of the second layer L2 in the light emitting connected portion CE. The length of the first tip portion TP1 in which the third end L3_W of the third layer L3 protrudes further outward than the second end L2_W of the second layer L2 may be defined as a first gap G1 between the third end L3_W of the third layer L3 and the second end L2_W of the second layer L2 in the extension portion CNL. The length of the second tip portion TP2 in which the third end L3_W of the third layer L3 protrudes further outward than the second end L2_W of the second layer L2 may be defined as a second gap G2 between the third end L3_W of the third layer L3 and the second end L2_W of the second layer L2 in the light emitting connected portion CE. According to an embodiment, the first gap G1 and the second gap G2 may be different from each other. By way of example, the second gap G2 may be greater than the first gap G1. Each of the first gap G1 and the second gap G2 is illustrated as being constant without being changed according to a position, but an embodiment is not limited thereto.

On the connection wiring CN, the sixth insulation layer 60 disposed. On the sixth insulation layer 60, an open region OP exposing at least a portion of the light emitting connected portion CE may be provided. However, an embodiment is not limited thereto, and the open region OP may expose a portion of the light emitting connected portion CE and a portion of the extension portion CNL. The open region OP corresponds to the first opening OP1 illustrated in FIG. 5. According to an embodiment, the second tip portion TP2 may be defined in the open region OP. For example, the second tip portion TP2 may not be covered by the sixth insulation layer 60 but be exposed through the open region OP. The first tip portion TP1 may not overlap the open region OP. The first tip portion TP1 may be surrounded by the sixth insulation layer 60 and not be exposed.

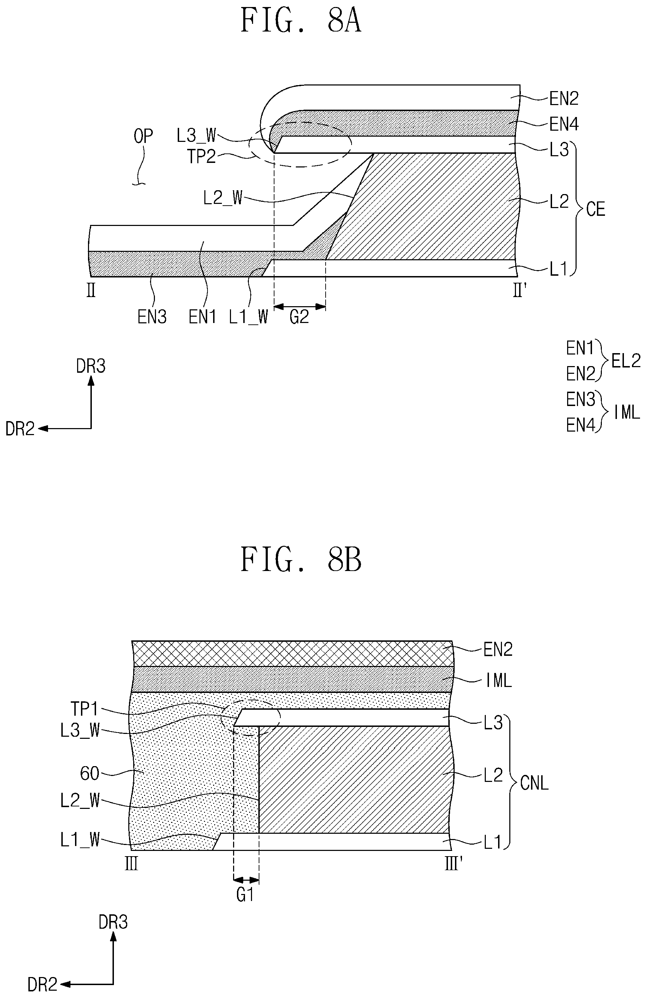

FIG. 8A is a schematic cross-sectional view showing a light emitting connected portion corresponding to line II - II ' of FIG. 7. FIG. 8B is a schematic cross-sectional view showing a light emitting connected portion corresponding to line III-III' of FIG. 7.

Referring to FIG. 8A, the light emitting connected portion CE may include the first layer L1, the second layer L2 disposed on the first layer L1, and the third layer L3 disposed on the second layer L2. The second layer L2 has a relatively higher conductivity than the first layer L1 and the third layer L3. According to an embodiment, the first layer L1 may include titanium (Ti), the second layer L2 may include aluminum (Al) or copper (Cu), and the third layer L3 may include titanium (Ti). However, an embodiment is not limited thereto, and the first layer L1 and the third layer L3 may include different materials, and the second layer L2 may include a material different from that of at least one of the first layer L1 and the third layer L3.

According to an embodiment, the second layer L2 and the third layer L3 may be disposed to have an undercut shape at a position at which the second tip portion TP2 is provided. The protrusion length of the second tip portion TP2 (for example, the length in which the third end L3_W of the third layer L3 of the second tip portion TP2 protrudes further outward from the second end L2_W of the second layer L2) may be defined as the second gap G2, wherein the second gap G2 may be in a range of about 1 µm to about 4 µm.

A portion of the middle layer IML may be disposed on the light emitting connected portion CE, and a portion of the second electrode EL2 may be disposed on the middle layer IML. By way of example, a portion of the middle layer IML may be directly disposed on the third layer L3 included in the light emitting connected portion CE. However, an embodiment is not limited thereto, and although not illustrated, the light emitting layer EML (see FIG. 5) may be further disposed between a portion of the third layer L3 and a portion of the middle layer IML.

A portion of the second electrode EL2 and a portion of the middle layer IML may be disposed below the second tip portion TP2. Each of the second electrode EL2 and the middle layer IML is partially disconnected by the second tip portion TP2. A first end EN1 and a second end EN2 which are disconnected from each other with respect to the second tip portion TP2 may be defined in the second electrode EL2. The first end EN1 and the second end EN2 may correspond to one end EN1 and the other end EN2 of the second electrode EL2 described above. A third end EN3 and a fourth end EN4 which are disconnected from each other with respect to the second tip portion TP2 may be defined in the middle layer IML. The third end EN3 and the fourth end EN4 may correspond to one end IN1 and the other end IN2 of the middle layer IML described above. The first end EN1 of the second electrode EL2 is disposed on the third end EN3 of the middle layer IML to cover the third end EN3. The first end EN1 is formed along the second layer L2 and is in direct contact with the second end L2_W of the second layer L2. For example, since the first end EN1 of the second electrode EL2 is in direct contact with the second end L2_W of the second layer L2 having a relatively higher conductivity than the first layer L1 and the third layer L3, the second electrode EL2 may be electrically connected to the connection wiring CN (see FIG. 5).

The third end EN3 of the middle layer IML may be disposed below the first end EN1. The third end EN3 is illustrated as being in contact with the second end L2_W of the second layer L2, but is not limited thereto, and the third end EN3 of the middle layer IML may not be in contact with the second end L2_W of the second layer L2 and may be in contact with only the first layer L1.

The fourth end EN4 may be disposed on the third layer L3 as the middle layer IML is disconnected by the second tip portion TP2. The fourth end EN4 may be formed to cover the third end L3_W of the third layer L3 through a difference in deposition angle during a deposition process. The second end EN2 may be disposed on the fourth end EN4 as the second electrode EL2 is disconnected by the second tip portion TP2. The second end EN2 may be formed to cover one end or an end of the fourth end EN4 through a difference in deposition angle during the deposition process.

The middle layer IML and the second electrode EL2 may be formed through deposition. By adjusting the deposition angle of the middle layer IML and the deposition angle of the second electrode EL2 to be different from each other, even in case that the second electrode EL2 is disposed on the middle layer IML, it is possible to form the first end EN1 of the second electrode EL2 to cover the third end EN3 of the middle layer IML and to be in contact with the second end L2_W of the second layer L2. Accordingly, the second electrode EL2 may be electrically connected to the connection transistor TR (see FIG. 5) through the connection wiring CN (see FIG. 5) without a separate patterning process and the like within the scope of the claims.

Referring to FIG. 8B, the extension portion CNL may include the first layer L1, the second layer L2 disposed on the first layer L1, and the third layer L3 disposed on the second layer L2. On the extension portion CNL, the sixth insulation layer 60 may be disposed. By way of example, the sixth insulation layer 60 may be disposed to cover the first layer L1, the second layer L2, and the third layer L3 included in the extension portion CNL.

The middle layer IML may be disposed on the sixth insulation layer 60, and the second electrode EL2 may be disposed on the middle layer IML. However, an embodiment is not limited thereto, the light emitting layer EML (see FIG. 5) may be further disposed between the sixth insulation layer 60 and the middle layer IML.

According to an embodiment, the second end L2_W and the third end L3_W may be disposed to have an undercut shape at a position at which the first tip portion TP1 is provided. The protrusion length of the first tip portion TP1 (for example, the length in which the third end L3_W of the third layer L3 of the first tip portion TP1 protrudes further outward from the second end L2_W of the second layer L2) may be defined as the first gap G1, wherein the first gap G1 may be in a range of about 0.1 µm to about 0.4 µm.

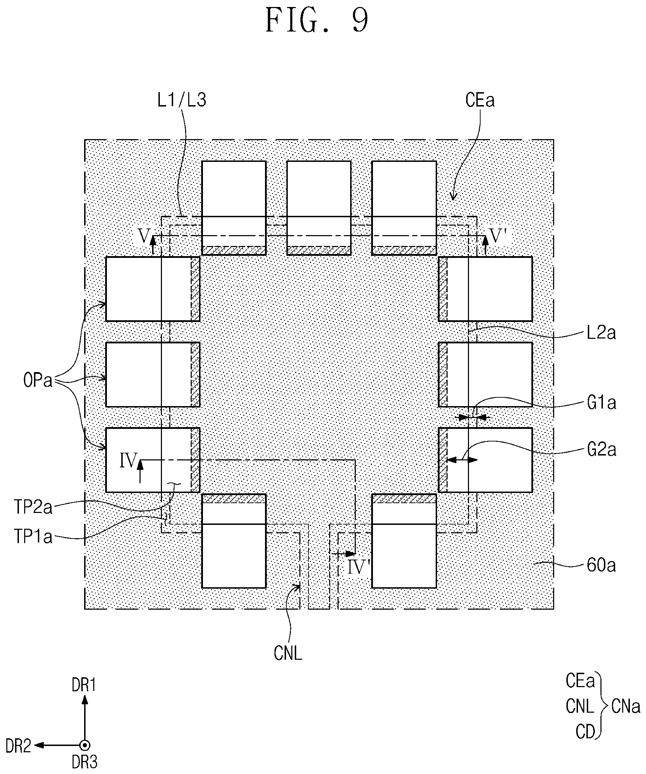

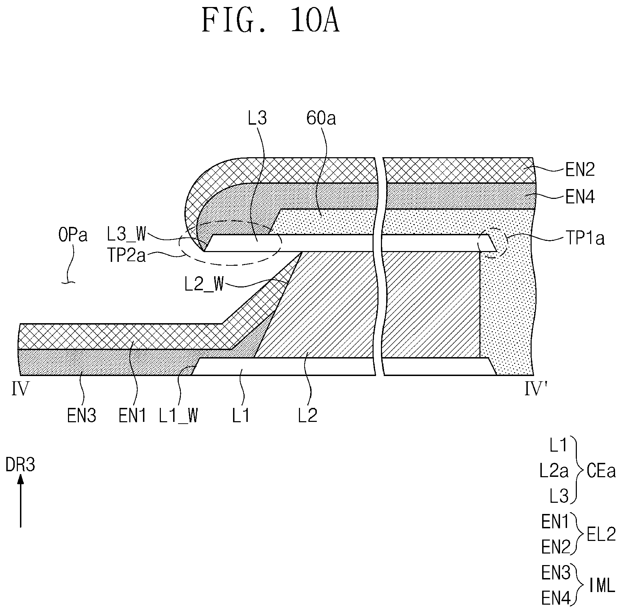

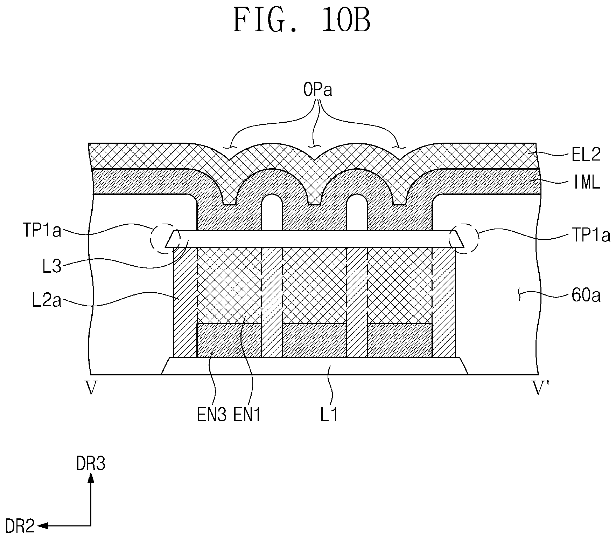

FIG. 9 is a schematic plan view showing a light emitting connected portion according to an embodiment. FIG. 10A is a schematic cross-sectional view of a light emitting connected portion showing a portion corresponding to line IV-IV' of FIG. 9. FIG. 10B is a schematic cross-sectional view of a light emitting connected portion showing a portion corresponding to line V-V' of FIG. 9.

Referring to FIG. 5, FIG. 9, and FIG. 10A, a connection wiring CNa may include a light emitting connected portion CEa, a driving connected portion CD, and an extension portion CNL. Each of the light emitting connected portion CEa, the driving connected portion CD, and the extension portion CNL may include a first layer L1, a second layer L2, and a third layer L3, and the second electrode EL2 and the connection transistor TR may be electrically connected to each other through the light emitting connected portion CEa, the driving connected portion CD, and the extension portion CNL.

According to an embodiment, the light emitting connected portion CEa may include a first tip portion TP1a and a second tip portion TP2a. The protrusion length of the first tip portion TP1a, for example, a first gap G1a, and the protrusion length of the second tip portion TP2a, for example, a second gap G2a, may be different from each other. By way of example, the second gap G2a may be greater than the first gap G1a. The second gaps G2a are each illustrated as being constant, but an embodiment is not limited thereto, and second gaps G2a may be different from each other.

On the connection wiring CNa, a sixth insulation layer 60a is disposed. On the sixth insulation layer 60a, an open region OPa exposing at least a portion of the light emitting connected portion CEa may be provided. According to an embodiment, open regions OPa may be provided on the sixth insulation layer 60a. The number of the open regions OPa is not limited, and the open regions OPa exposing at least a portion of the extension portion CNL may be provided.

The second tip portion TP2a may be defined in the open region OPa. For example, the second tip portion TP2a may not be covered by the sixth insulation layer 60a but be exposed through the open region OPa. The first tip portion TP1a may not overlap the open region OPa. The first tip portion TP1a may be surrounded by the sixth insulation layer 60a and not be exposed. According to an embodiment, the second tip portion TP2a may be provided in plurality corresponding to the open regions OPa. By way of example, the second tip portion TP2a may be formed in each of the open regions OPa. The size of each of the open regions OPa is not limited, and a width parallel to a third end L3_W of a third layer L3 of the second tip portion TP2a may be determined in correspondence to a width parallel to a third end L3_W of a third layer L3 of the open regions OPa.

Second tip portions TP2a may be partially provided in the light emitting connected portion CEa. In case that the second tip portions TP2a of the disclosure are partially provided in the light emitting connected portion CEa, in case that compared to an embodiment of FIG. 7 in which the second tip portion TP2a is formed in the entire light emitting connected portion CEa, the length (the width parallel to the third end L3_W) of each of the second tip portions TP2a may be less than the length (a width parallel to the second end L2_W) of the second tip portion TP2. Accordingly, a phenomenon (hereinafter, a lifting phenomenon) in which the third end L3_W of the third layer L3 is lifted by a cleaning process or the like during a subsequent process, or a phenomenon (hereinafter, a collapse phenomenon) in which the third end L3_W of the third layer L3 collapses may be prevented, and a reliable display panel DP (see FIG. 5) may be provided.

Referring to FIG. 10A, on the light emitting connected portion CEa, the sixth insulation layer 60a is disposed, and the sixth insulation layer 60a may cover one end or an end of the light emitting connected portion CEa. By way of example, the sixth insulation layer 60a may cover one end or an end of the first layer L1, a second layer L2a, and the third layer L3. In a region in which the sixth insulation layer 60a covers the first layer L1, the second layer L2a, and the third layer L3, the first tip portion TP1a may be provided. In a region in which the sixth insulation layer 60a does not the first layer L1, the second layer L2a, and the third layer L3, for example, the open region OPa, the second tip portion TP2a may be provided.

Each of the second electrode EL2 and the middle layer IML is partially disconnected by the second tip portion TP2a. The second electrode EL2 may include the first end EN1 and the second end EN2 which are disconnected from each other with respect to the second tip portion TP2a. The middle layer IML may include the third end EN3 and the fourth end EN4 which are disconnected from each other with respect to the second tip portion TP2a. The first end EN1 is disposed on the third end EN3 to cover the third end EN3. The first end EN1 is formed along the second layer L2a and is in direct contact with a second end L2_Wa of the second layer L2a. For example, since the first end EN1 of the second electrode EL2 is in direct contact with an end of the second layer L2a having a relatively higher conductivity than the first layer L1 and the third layer L3, the second electrode EL2 may be electrically connected to the connection wiring CNa.

Referring to FIG. 10B, the light emitting connected portion CEa may further include first tip portions TP1a provided in the region in which the sixth insulation layer 60a covers the first layer L1, the second layer L2a, and the third layer L3. By way of example, the six insulation layer 60a may include open regions OPa, and the first tip portion TP1a may not overlap the open region OPa. The first tip portion TP1a may be provided in plurality between the open regions OPa.

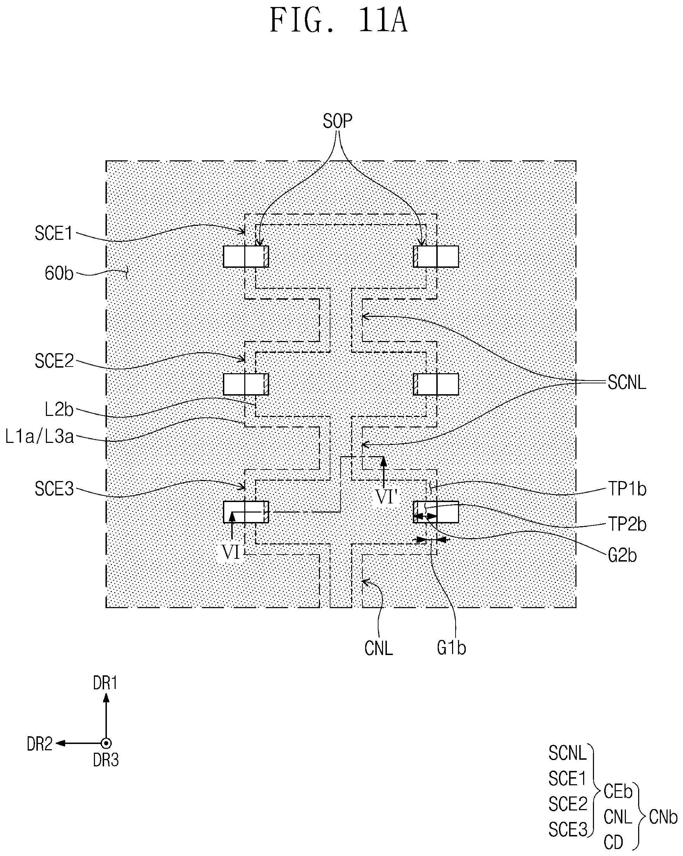

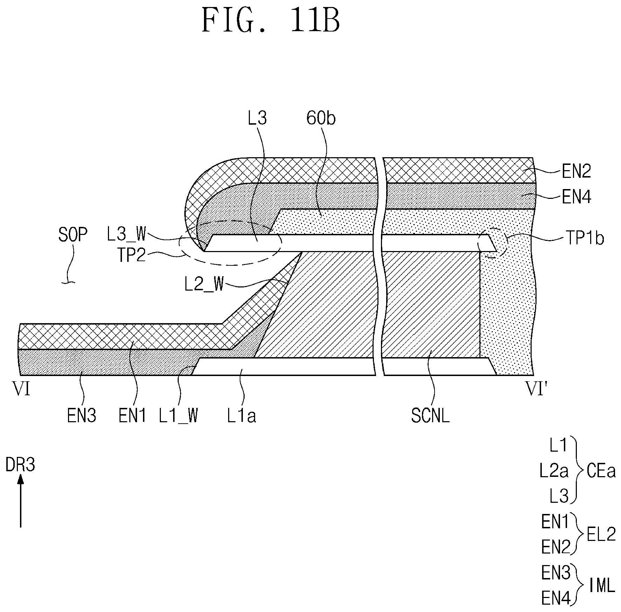

FIG. 11A is a schematic plan view showing a light emitting connected portion according to an embodiment. FIG. 11B is a schematic cross-sectional view showing a light emitting connected portion corresponding to line VI-VI' of FIG. 11A.

Referring to FIG. 11A, a connection wiring CNb may include a light emitting connected portion CEb, a driving connected portion CD, and an extension portion CNL. The light emitting connected portion CEb may include sub-light emitting connected portions SCE1, SCE2, and SCE3. The sub-light emitting connected portions SCE1, SCE2, and SCE3 may be electrically connected to each other. By way of example, the light emitting connected portion CEb may further include a sub-extension portion SCNL electrically connecting the sub-light emitting connected portions SCE1, SCE2, and SCE3.

On the connection wiring CNb, a sixth insulation layer 60b is disposed. On the sixth insulation layer 60b, a sub-open region SOP exposing at least a portion of the light emitting connected portion CEb may be provided. According to an embodiment, sub-open regions SOP may be provided on the sixth insulation layer 60b. The number of the sub-open regions SOP is not limited as illustrated.

According to an embodiment, the sixth insulation layer 60b may include a sub-open region SOP exposing a portion of at least one of the sub-light emitting connected portions SCE1, SCE2, and SCE3. For example, the sixth insulation layer 60b may include a sub-open region SOP exposing only a portion of a first sub-light emitting connected portion SCE1 among the sub-light emitting connected portions SCE1, SCE2, and SCE3, or may include sub-open regions SOP exposing a portion of each of the sub-light emitting connected portions SCE1, SCE2, and SCE3. However, an embodiment is not limited thereto, and the sub-open regions SOP may be formed to expose a portion of each of the sub-light emitting connected portions SCE1, SCE2, and SCE3.

According to an embodiment, the light emitting connected portion CEb may include a first tip portion TP1b and a second tip portion TP2b. By way of example, each of the sub-light emitting connected portions SCE1, SCE2, and SCE3 may include the first tip portion TP1b and the second tip portion TP2b. The first tip portion TP1b and the second tip portion TP2b may be defined as a portion in which a third end L3_W of a third layer L3a protrudes further outward than a second end L2_W of a second layer L2b in the light emitting connected portion CEb. The protrusion length of the first tip portion TP1b, for example, a first gap G1b, and the protrusion length of the second tip portion TP2b, for example, a second gap G2b, may be different from each other. By way of example, the second gap G2b may be greater than the first gap G1b. The second gaps G2b are each illustrated as being constant, but an embodiment is not limited thereto, and second gaps G2b may be different from each other.

According to an embodiment, the second tip portion TP2b may be defined in the sub-open region SOP. For example, the second tip portion TP2b may not be covered by the sixth insulation layer 60b but be exposed through the sub-open region SOP. The first tip portion TP1b may not overlap the sub-open region SOP. The first tip portion TP1b may be surrounded by the sixth insulation layer 60b and not be exposed. According to an embodiment, the second tip portion TP2b may be provided in plurality corresponding to the sub-open regions SOP. By way of example, the second tip portion TP2b may be formed in each of the sub-open regions SOP. The first tip portion TP1b may be provided between the sub-open regions SOP. Therefore, each of the sub-light emitting connected portions SCE1, SCE2, and SCE3 may include first tip portions TP1b not overlapping the sub-open region SOP. The size of each of the sub-open regions SOP is not limited as illustrated. A width parallel to a third end L3_W of a third layer L3a of the second tip portion TP2b may be determined in correspondence to a width parallel to a third end L3_W of a third layer L3a of the sub-open regions SOP.

According to an embodiment, the sub-extension portion SCNL may include the first tip portion TP1b. However, an embodiment is not limited thereto, and the sub-extension portion SCNL may further include the second tip portion TP2b.

Referring to FIG. 11B, the light emitting connected portion CEb may include a first layer L1a, a second layer L2b disposed on the first layer L1a, and a third layer L3a disposed on the second layer L2b. On the light emitting connected portion CEb, the sixth insulation layer 60b is disposed, and the sixth insulation layer 60b may cover one end or an end of the light emitting connected portion CEb. By way of example, the sixth insulation layer 60b may cover one end or an end of the first layer L1a, a second layer L2b, and the third layer L3a. In region in which the sixth insulation layer 60b covers the first layer L1a, the second layer L2b, and the third layer L3a, the first tip portion TP1b may be provided. In a region in which the sixth insulation layer 60b does not cover the first layer L1a, the second layer L2b, and the third layer L3a, for example, the sub-open region SOP, the second tip portion TP2b may be provided.

According to an embodiment, second tip portions TP2b may be partially provided in each of the sub-light emitting connected portions SCE1, SCE2, and SCE3. In case that the second tip portions TP2b of the disclosure are partially provided in each of the sub-light emitting connected portions SCE1, SCE2, and SCE3, in case that compared to a comparative embodiment in which the second tip portions TP2b are formed in the entire sub-light emitting connected portions SCE1, SCE2, and SCE3, the length (a width parallel to the third end L3_W) of each of the second tip portions TP2b may be less than the length (a width parallel to the third end L3_W) of the second tip portion TP2. Accordingly, a phenomenon (hereinafter, a lifting phenomenon) in which the third end L3_W of the third layer L3 is lifted by a cleaning process or the like during a subsequent process, or a phenomenon (hereinafter, a collapse phenomenon) in which the third end L3_W of the third layer L3 collapses may be prevented, and a reliable display panel DP (see FIG. 5) may be provided.

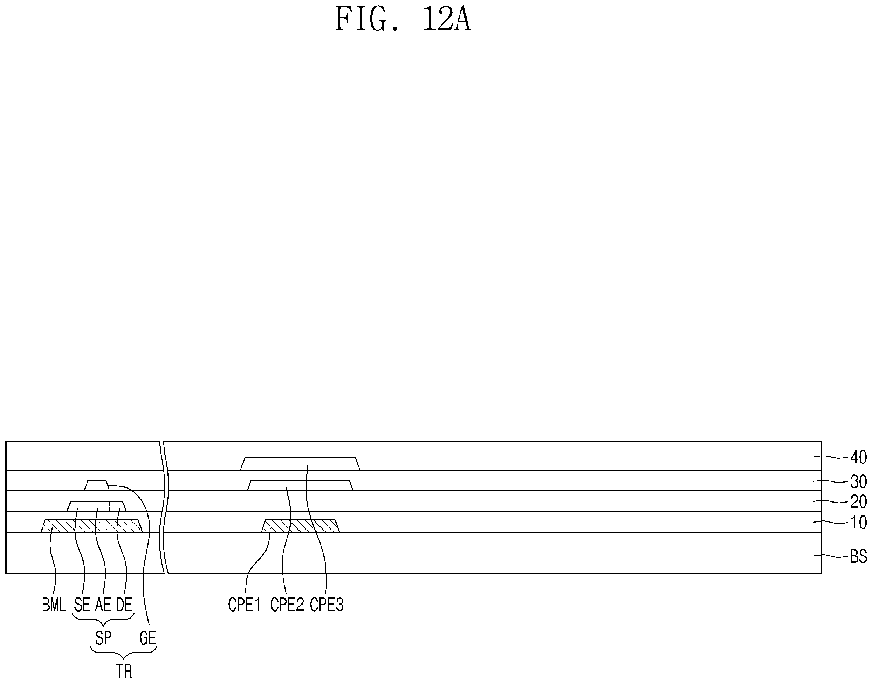

FIG. 12A to FIG. 12H are process diagrams showing steps of manufacturing a display panel according to an embodiment. Hereinafter, the same reference numerals are given to the same components as those described with reference to FIG. 1 to FIG. 11B, and redundant descriptions thereof may be omitted.

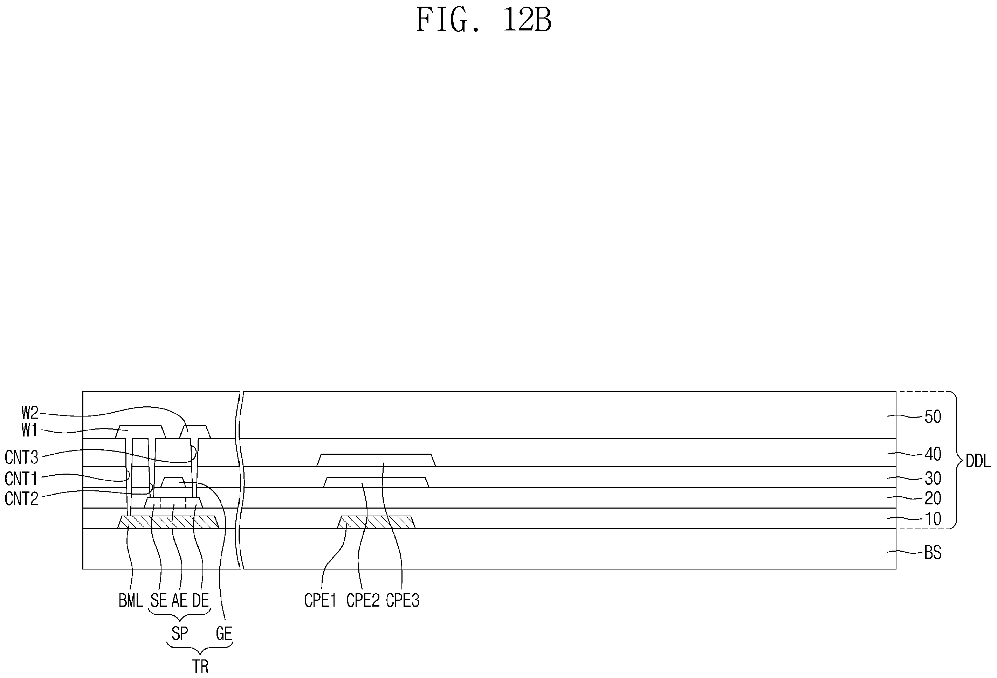

Referring to FIGS. 12A and 12B, a driving element layer including a transistor and a fifth insulation layer 50 is formed on a base layer BS. The forming of a driving element layer may include forming a connection transistor TR on the base layer BS, and providing the fifth insulation layer 50 covering the connection transistor TR.

An organic layer, an inorganic layer, a semiconductor pattern, a conductive pattern, and a signal line may be formed on the base layer BS by coating, deposition, or the like within the scope of the claims. Thereafter, the organic layer, the inorganic layer, the semiconductor layer, and the conductive layer may be selectively patterned through photolithography processes to form an insulation layer, a semiconductor pattern, a conductive pattern, and a signal line.

By way of example, a lower metal layer BML may be formed on the base layer BS. The lower metal layer BML may be formed by coating or depositing a metal material on the base layer BS, and patterning the metal material. A first capacitor electrode CPE1 and the lower metal layer BML may be disposed on the same layer. At this time, the first capacitor electrode CPE1 may be formed by being simultaneously patterned with the lower metal layer BML through one mask from the same material layer. Accordingly, the process may be simplified and process costs may be reduced. However, this is described as an example, and the first capacitor electrode CPE1 and the lower metal layer BML may be formed by different processes, and are not limited to any one embodiment.

Thereafter, a first insulation layer 10 is formed to cover the first capacitor electrode CPE1 and the lower metal layer BML. The first insulation layer 10 may be formed by depositing an insulation material, for example, an inorganic material, on the base layer BS.

Thereafter, on the first insulation layer 10, a semiconductor pattern SP may be formed. The semiconductor pattern SP may be formed by coating or depositing a semiconductor material on the first insulation layer 10, and patterning the semiconductor material. The semiconductor material may include single crystal silicon, polycrystalline silicon, or an oxide semiconductor. In an embodiment, an embodiment in which the semiconductor pattern SP is formed of an oxide semiconductor will be described as an example.

Thereafter, a second insulation layer 20 is formed to cover the semiconductor pattern SP. The second insulation layer 20 may be formed by depositing an insulation material, for example, an inorganic material, on the first insulation layer 10.

Thereafter, the connection transistor TR may be formed by forming a gate electrode GE on the second insulation layer 20. The gate electrode GE may be formed by coating or depositing a metal material on the second insulation layer 20, and patterning the metal material.

Thereafter, a source SE, a drain DE, and a channel AE are formed in the semiconductor pattern SP. The source SE and the drain DE may be formed by reducing a region of the semiconductor pattern SP that does not overlap the gate electrode GE. By way of example, in case that the semiconductor pattern SP is formed of silicon, the source SE and the drain DE may be formed by injecting a dopant to a region of the semiconductor pattern SP that does not overlap the gate electrode GE. The source SE, the drain DE, and the channel AE may be formed before the gate electrode GE is formed, and are not limited to any one embodiment.

A second capacitor electrode CPE2 and the gate electrode GE may be disposed on the same layer. At this time, the second capacitor electrode CPE2 may be formed by being simultaneously patterned with the gate electrode GE through one mask from the same material layer. Accordingly, the process may be simplified and process costs may be reduced. However, this is described as an example, and the second capacitor electrode CPE2 and the gate electrode GE may be formed by different processes, and are not limited to any one embodiment.

Thereafter, a third insulation layer 30 is formed to cover the gate electrode GE and the second capacitor electrode CPE2. The third insulation layer 30 may be formed by depositing an insulation material, for example, an inorganic material, on the second insulation layer 20.

Thereafter, a third capacitor electrode CPE3 and a fourth insulation layer 40 are sequentially formed. The third capacitor electrode CPE3 may be formed by depositing (or coating) a metal material and patterning the metal material. The fourth insulation layer 40 may be formed by depositing an insulation material, for example, an inorganic material, on the third insulation layer 30. This is an example as illustrated, and the process sequence between the first to third capacitor electrodes CPE1, CPE2, and CPE3 and the insulation layers 10, 20, 30, and 40 may be changed in various ways according to positions of the first to third capacitor electrodes CPE1, CPE2, and CPE3, and is not limited to any one embodiment.

Thereafter, on the fourth insulation layer 40, a source electrode pattern W1 and a drain electrode pattern W2 are formed. First, on the fourth insulation layer 40, through-holes CNT1, CNT2, and CNT3 are formed. A first through-hole CNT1 is formed by passing through the first to fourth insulation layers 10, 20, 30, and 40 such that one side or a side of the lower metal layer BML is exposed. A second through-hole CNT2 is formed by passing through the second to fourth insulation layers 20, 30, and 40 such that at least a portion of the sources CE of the semiconductor pattern SP is exposed. A third through-hole CNT3 is formed by passing through the second to fourth insulation layers 20, 30, and 40 such that at least a portion of the drain DE of the semiconductor pattern SP is exposed.

Thereafter, a metal material is deposited or coated on the fourth insulation layer 40, and patterned to form the source electrode pattern W1 and the drain electrode pattern W2. The source electrode pattern W1 and the drain electrode pattern W2 may be formed while filling a corresponding through-hole among the through-holes CNT1, CNT2, and CNT3. This is an example as illustrated, and in the method for manufacturing a display panel according to an embodiment, a step of forming the source electrode pattern W1 or the drain electrode pattern W2 may be omitted. A connection wiring CN to be described later may be directly connected to the semiconductor pattern SP by passing through the first to fourth insulation layers 10, 20, 30, and 40.

On the fourth insulation layer 40, the fifth insulation layer 50 covering the source electrode pattern W1 and the drain electrode pattern W2 may be formed. The fifth insulation layer 50 may be formed by depositing an insulation material, for example, an inorganic material, on the fourth insulation layer 40.

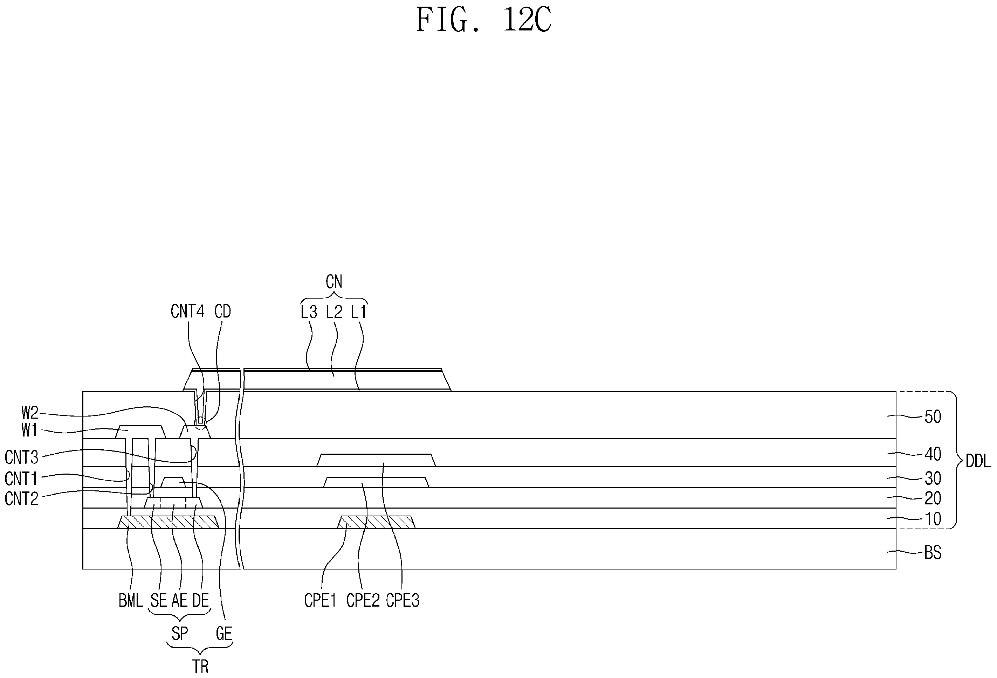

Referring to FIG. 12C, a contact-hole CNT4 exposing the drain electrode pattern W2 may be formed on the fifth insulation layer 50. In case that the step of forming the source electrode pattern W1 or the drain electrode pattern W2 may omitted, the contact-hole CNT4 may be formed to expose the semiconductor pattern SP.

On the fifth insulation layer 50, the connection wiring CN may be formed. One side or a side of the connection wiring CN is connected to the connection transistor TR through the contact-hole CNT4 formed in the fifth insulation layer 50. Here, the one side or the side connected to the connection transistor TR may be defined as a driving connected portion CD.

The connection wiring CN may include a first layer L1, a second layer L2, and a third layer L3. A metal material layer forming the first layer L1, a metal material layer forming the second layer L2, and a metal material layer forming the third layer L3 are sequentially formed on the fifth insulation layer 50, and the first to third layers L1, L2, and L3 are patterned to form the connection wiring CN. At this time, the second layer L2 and the third layer L3 may be formed of different materials. By way of example, the second layer L2 may be formed of a material having a higher etch rate than that of the third layer L3 with respect to a selectable etchant or etching gas. For example, the second layer L2 may be formed of aluminum, and the third layer L3 may be formed of titanium, but an embodiment is not limited thereto.

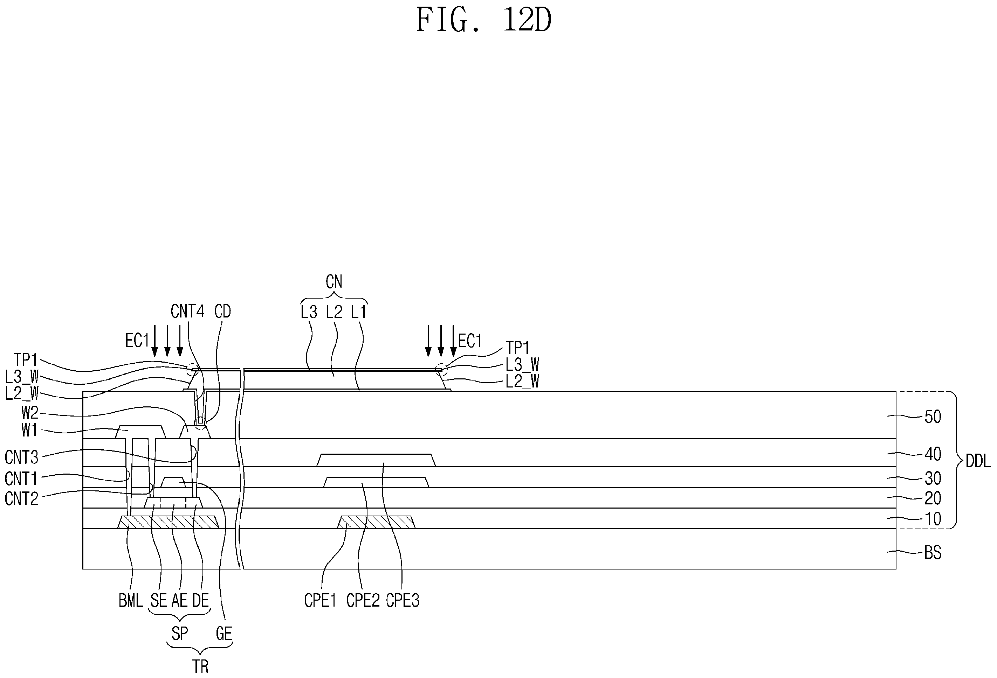

Thereafter, referring to FIG. 12D, forming a first tip portion TP1 in the connection wiring CN may include performing primary etching on the connection wiring CN.

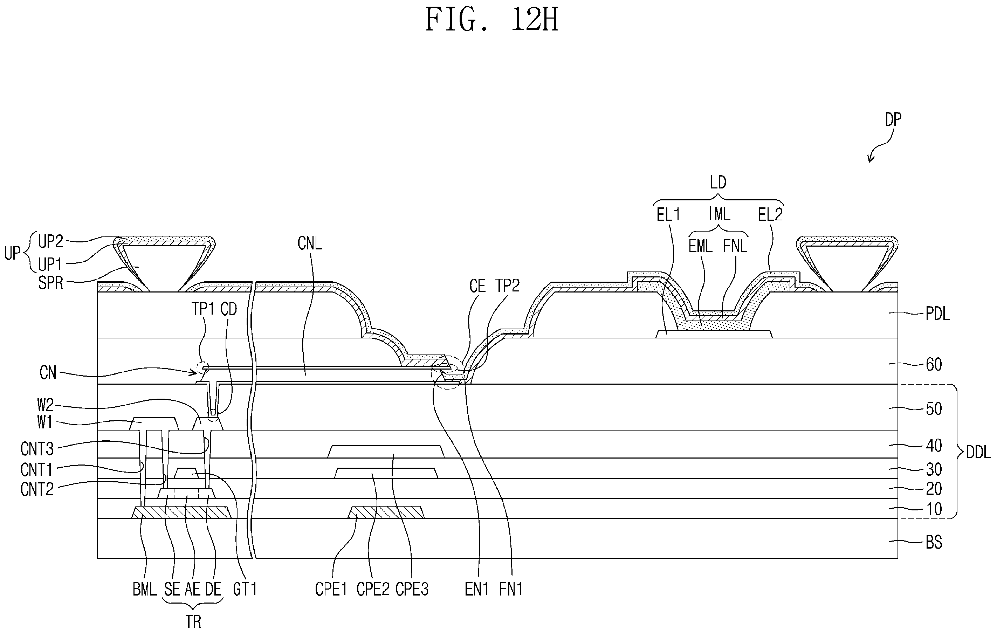

Performing primary etching on the first to third layers L1, L2, and L3 may include a wet etching step. As an example of the disclosure, the primary etching may be performed using an etching solution having a different etch selection ratio with respect to the second layer L2 and the third layer L3. During the primary etching process, a light emitting connected portion CE (see FIG. 12H), a driving connected portion CD and an extension portion CNL (see FIG. 12H) of the connection wiring may be primarily etched. As a result of primary etching EC1, an end L2_W of the second layer L2 having a higher etch selection ratio than the third layer L3 may be recessed further inward than an end L3_W of the third layer L3. Accordingly, the first tip portion TP1 in which the end L3_W of the third layer L3 protrudes from the end L2_W of the second layer L2 may be formed in the light emitting connected portion CE, the driving connected portion CD, and the extension portion CNL.

The length of the first tip portion TP1, for example, a protrusion length in which the end L3_W of the third layer L3 protrudes from the end L2_W of the second layer L2, may be formed in various ways depending on the concentration of an etchant, etching time, or etch selection ratio. According to an embodiment, the primary etching EC1 may be performed for about 10 seconds, and the protrusion length of the first tip portion TP1 may be formed to be in a range of about 0.1 µm to about 1 µm.

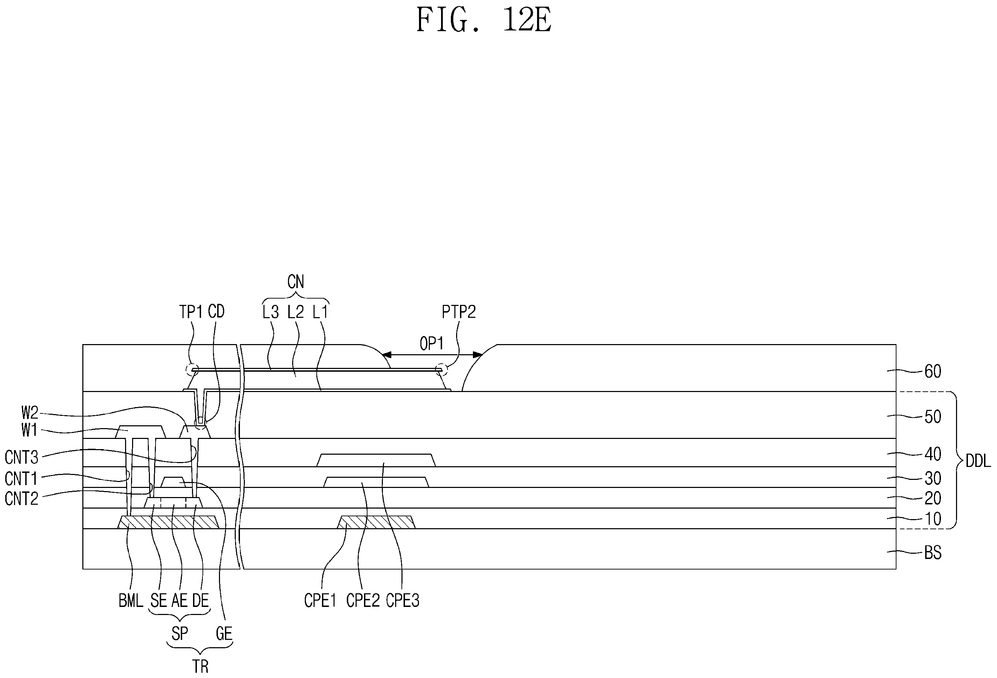

Referring to FIG. 12E, a sixth insulation layer 60 is provided on the fifth insulation layer 50 to cover the connection wiring CN. A first opening OP1 is formed on the sixth insulation layer 60 to expose the light emitting connected portion CE (see FIG. 12H) of the connection wiring CN.

Thereafter, the first opening OP1 exposing one side or a side of the light emitting connected portion CE of the connection wiring CN is formed on the sixth insulation layer 60. The one side or the side of the light emitting connected portion CE may be one side or a side connected to the connection transistor TR, for example, a side opposite to the side on which the driving connected portion CD is defined. Since the first tip portion TP1 formed in the light emitting connected portion CE is exposed by the first opening OP1, a second preliminary tip portion PTP2 may be formed. For example, the first tip portion TP1 of the light emitting connected portion CE that is exposed through the first opening OP1 may be referred to as the second preliminary tip portion PTP2. The forming of the second preliminary tip portion PTP2 may include exposing the first tip portion TP1.

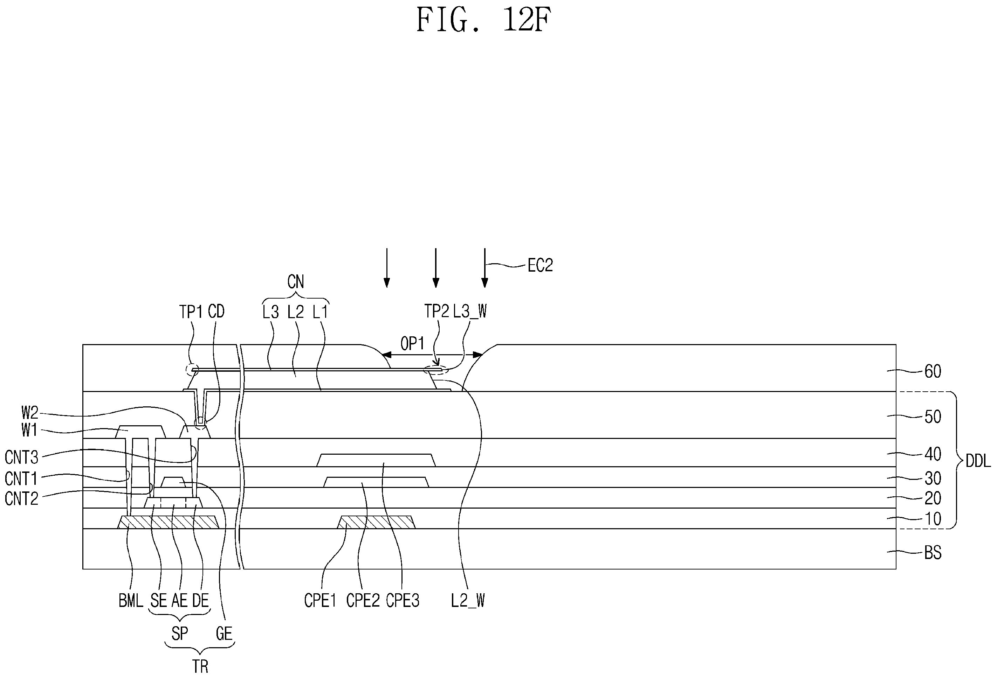

Thereafter, referring to FIG. 12F, forming a second tip portion TP2 on one side or a side of the light emitting connected portion CE may be performed. The forming of the second tip portion TP2 may include performing secondary etching EC2 on the second preliminary tip portion PTP2. The performing of the secondary etching EC2 may include performing the secondary etching EC2 on one side or a side of the light emitting connected portion CE that is exposed through the first opening OP1.

In an embodiment, performing secondary etching on the first to third layers L1, L2, and L3 may include a wet etching step. As an example of the disclosure, the secondary etching may be performed using an etching solution having a different etch selection ratio with respect to the second layer L2 and the third layer L3. A solution for the primary etching and a solution for the secondary etching may be the same. As a result of the secondary etching EC2, the end L2_W of the second layer L2 having a higher etch rate than the third layer L3 may be recessed further inward than the end L3_W of the third layer L3. Accordingly, the second tip portion TP2 may be formed. As a result of the secondary etching EC2, the length of the second tip portion TP2 may be greater than the length of the first tip portion TP1. According to an embodiment, the time for the secondary etching EC2 may be the same as or different from the time for the primary etching EC1. As an example of the disclosure, the time for the secondary etching EC2 may be longer than the time for the primary etching EC1. For example, the secondary etching EC2 may be performed for about 30 seconds. The length of the second tip portion TP2 may be formed to be in a range of about 1 µm to about 4 µm.

In case that compared to a comparative embodiment in which the primary etching EC1 step may be omitted, the disclosure further includes the primary etching EC1 step before the secondary etching EC2 step, so that it is possible to prevent or reduce the formation of an oxide film around the second layer L2 in the light emitting connected portion CE. Therefore, it is possible to prevent a phenomenon in which the light emitting connected portion CE and the second electrode EL2 are not normally connected, and as a result, it is possible to provide a display panel with improved process reliability.

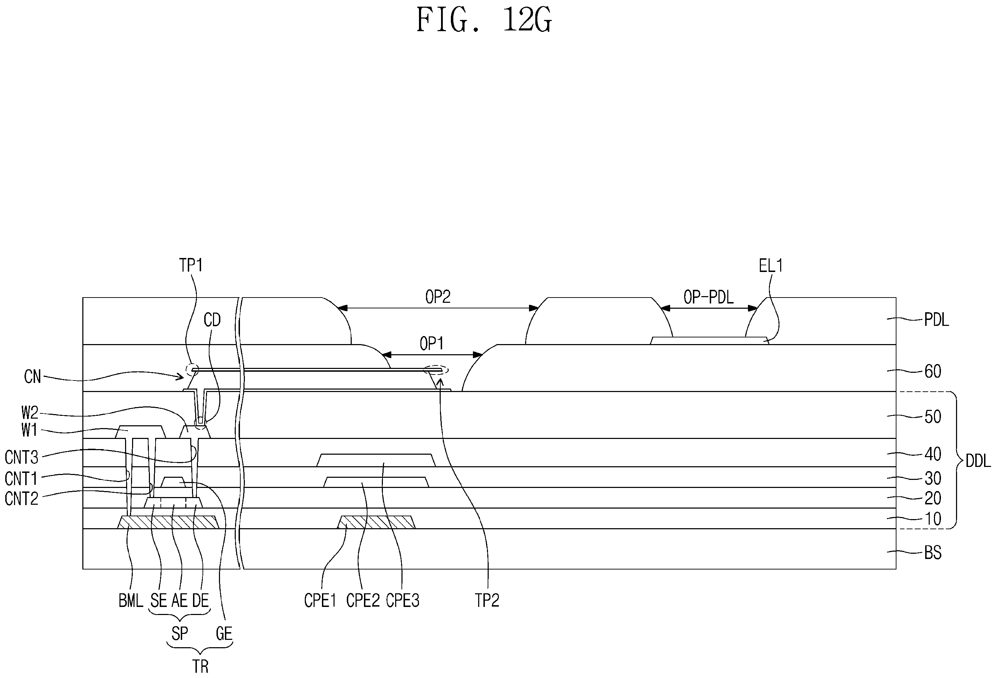

Referring to FIG. 12G, forming a first electrode EL1 may include forming the first electrode EL1 on the sixth insulation layer 60. The first electrode EL1 may be formed by depositing or coating a metal material on the sixth insulation layer 60, and patterning the metal material.

Thereafter, forming a pixel definition film PDL may be performed. The pixel definition film PDL may be formed by depositing or coating an insulation material on the sixth insulation layer 60, and patterning the insulation material. On the pixel definition film POL, a second opening OP2 and a pixel opening OP-PDL may be formed. The second opening OP2 is formed in a region overlapping the first opening OP1 and exposes the second tip portion TP2. The pixel opening OP-PDL is formed in a region overlapping the first electrode EL1 and exposes at least a portion of the first electrode EL1. The size and shape of the pixel opening OP-PDL may be designed to correspond to the size and shape of a light emitter described above.

The second opening OP2 and the pixel opening OP-PDL may be simultaneously formed through one mask. However, this is an example as described, and the second opening OP2 and the pixel opening OP-PDL may be sequentially patterned and formed through different processes, and are not limited to any one embodiment.

Thereafter, as illustrated in FIG. 12H, the method for manufacturing a display panel according to an embodiment may further include forming a separator SPR on the pixel definition film PDL.

The separator SPR may have a reverse tapered shape, but as described above, is not limited thereto. The separator SPR may be formed by coating an organic material, but an embodiment is not limited thereto. The separator SPR may have insulation properties.

Thereafter, forming a light emitting layer EML and forming a second electrode EL2 may be sequentially performed. The forming of the light emitting layer EML may be performed by depositing or coating a light emitting material on the pixel opening OP-PDL.

Thereafter, the second electrode EL2 is formed. At this time, forming a functional layer FNL may be further added, and the functional layer FNL may be formed before the second electrode EL2 is formed.

The functional layer FNL may be formed by depositing an organic material. The functional layer FNL may be formed on the entire base layer BS by using an open mask. At this time, it is difficult to form the functional layer FNL on a side surface of the separator SPR or in an undercut region (an end of a second layer) covered by the second tip portion TP2. The functional layer FNL may be disconnected by the separator SPR and may be disconnected by the second tip portion TP2. Accordingly, the functional layer FNL may be partitioned with respect to the separator SPR, and may have a shape disconnected by the second tip portion TP2. On an upper surface of the separator SPR, a first dummy layer UP1 disconnected from the functional layer FNL may be formed.

Thereafter, the second electrode EL2 is formed. The second electrode EL2 may be formed by depositing a metal material. The second electrode layer EL2 may be formed on the entire base layer BS by using an open mask. At this time, it is difficult to form the second electrode EL2 on the side surface of the separator SPR. The second electrode EL2 may be disconnected by the separator SPR, and may have a shape partitioned with respect to the separator SPR. On the upper surface of the separator SPR, a second dummy layer UP2 disconnected from the second electrode EL2 may be formed.

The second electrode EL2 is disconnected by the second tip portion TP2, but may be formed along an undercut region, for example, the end L2_W of the second layer L2, by controlling a deposition angle. For example, since the second electrode EL2 and the functional layer FNL are deposited at different deposition angles, the end L2_W of the second layer L2 may be exposed from the functional layer FNL and be covered by the second electrode EL2. Accordingly, the electrical connection between the second electrode EL2 and the connection wiring CN may be facilitated. The functional layer FNL may be electrically disconnected from the connection wiring CN without separate patterning. Since the connection wiring CN may be readily connected to the second electrode EL2 through the second tip portion TP2 without separate patterning, a light emitting element LD may be driven by an inverted element without a change in layer structure.

According to an embodiment, by including two etching processes for a light emitting connected portion, it is possible to prevent or reduce the formation of an oxide film around a tip in the light emitting connected portion. Therefore, it is possible to prevent a phenomenon in which the light emitting connected portion and the second electrode are not normally connected, and as a result, it is possible to provide a display panel with improved process reliability.

Although the disclosure has been described with reference to embodiments, it will be understood by those skilled in the art that various modifications and changes in form and details may be made therein without departing from scope of the disclosure as set forth in the following claims.

Accordingly, the technical scope of the disclosure is not intended to be limited to the contents set forth in the detailed description of the specification, but is intended to also be defined by the appended claims.

## Claims

1. A display panel (DP) comprising:
a transistor (TR);
a light emitting element (LD) including:
a first electrode (EL1);
a light emitting layer (EML) disposed on the first electrode (EL1); and
a second electrode (EL2) disposed on the light emitting layer (EML), the second electrode (EL2) being electrically connected to the transistor (TR); and
a connection wiring (CN) electrically connecting the transistor (TR) to the second electrode (EL2), wherein
the connection wiring (CN) includes:
a first connected portion (CE) electrically connected to the second electrode (EL2);
a second connected portion (CD) electrically connected to the transistor (TR); and
an extension portion (CN) extended from the first connected portion (CE) and electrically connecting the first connected portion (CE) and the second connected portion (CD),
each of the first connected portion (CE), the second connected portion (CD), and the extension portion (CN) includes:
a second layer (L2); and
a third layer (L3) disposed on the second layer (L2),
the second connected portion (CD) and the extension portion (CN) include a first tip portion (TP1),
the first connected portion (CE) includes a second tip portion (TP2), each of the first tip portion (TP1) and the second tip portion (TP2) is defined as a portion in which an end of the third layer (L3) protrudes further outward than an end of the second layer (L2), and protruding lengths of the first tip portion (TP1) and the second tip portion (TP2) are different from each other.

2. The display panel of claim 1, wherein
an insulation layer is disposed on the connection wiring, and
the insulation layer includes an open region exposing a portion of the first connected portion, wherein, optionally,
the first connected portion comprises the first tip portion, and
the second tip portion is defined in the open region, and
wherein, optionally, the first tip portion does not overlap the open region in a plan view, and
the protrusion length of the second tip portion is greater than the protrusion length of the first tip portion.

3. The display panel of claim 2, wherein
the open region includes open regions, and
the second tip portion includes second tip portions corresponding to the open regions.

4. The display panel of claim 2 or claim 3, wherein
the first connected portion comprises first sub-connected portions, and
the first sub-connected portions are electrically connected to each other.

5. The display panel of claim 4, wherein
the insulation layer comprises a sub-open region exposing a portion of at least one of the first sub-connected portions, and
the second tip portion is defined in the sub-open region.

6. The display panel of claim 5, wherein
the first sub-connected portion comprises the first tip portion, and
the first tip portion does not overlap the sub-open region in a plan view.

7. The display panel of any of claims 4 to 6, wherein the first connected portion comprises a sub-extension portion electrically connecting the first sub-connected portions.

8. The display panel of claim 7, wherein the sub-extension portion comprises the first tip portion.

9. The display panel of any of claims 5 to 8, wherein
the sub-open region includes sub-open regions, and
the second tip portion includes second tip portions corresponding to the sub-open regions.

10. The display panel of any preceding claim, wherein
the second electrode is partially disconnected by the second tip portion, and
a first end and a second end which are disconnected are defined in the second electrode,, wherein, optionally,
a first layer is disposed below the second layer,
the first end contacts the first layer and the second layer at the second tip portion, and
the second end is disposed on the third layer.

11. The display panel of any preceding claim, wherein the first connected portion, the extension portion, and the second connected portion are disposed on a same layer.

12. A method for manufacturing a display panel, the method comprising:
forming a driving element layer (DDL) including a transistor (TR) and a first insulation layer (10) on a base layer (BS);
forming a contact-hole (CNT1) partially exposing the transistor (TR);
providing a connection wiring (CN) electrically connected to the transistor (TR) through the contact-hole (CNT1) on the first insulation layer (10);
forming a first tip portion by primary etching (EC1) on the connection wiring (CN);
providing a second insulation layer (60) covering the connection wiring (CN);
forming a first open region (OP1) on the second insulation layer (60) to partially expose the first tip portion (TP1) thereby providing the first tip portion exposed by the first open region (OP1) as a second preliminary tip portion (PTP2); and
forming a second tip portion (TP2) by secondary etching (EC2) on the second preliminary tip portion (PTP2), wherein
the connection wiring (CN) includes:
a first layer (L1);
a second layer (L2) disposed on the first layer (L1); and
a third layer (L3) disposed on the second layer (L2),
in each of the first tip portion (TP1) and the second tip portion (TP2), an end of the third layer (L3) protrudes from an end of the second layer (L2), and
protrusion lengths of the first tip portion (TP1) and second tip portion (TP2) are different.

13. The method of claim 12, wherein the providing of the second preliminary tip portion comprises exposing the first tip portion.

14. The method of claim 12 or claim 13, further comprising:
forming a first electrode on the second insulation layer;
forming a pixel definition film on which a second open region exposing the second tip portion and a pixel opening exposing the first electrode are defined; and
providing a light emitting layer and a second electrode on the first electrode,
wherein the providing of the second electrode includes connecting the second electrode to the second tip portion, wherein, optionally, the connection wiring comprises:
a first connected portion electrically connected to the second electrode;
a second connected portion electrically connected to the transistor; and
an extension portion extended from the first connected portion and electrically connecting the first connected portion and the second connected portion and,
wherein, optionally,
the forming of the first tip portion comprises etching the first connected portion, the extension portion, and the second connected portion; and
the forming of the second tip portion comprises etching a side of the first connected portion.

15. The method of any of claims 12 to 14, wherein a primary etching time and a secondary etching time are different, and
wherein, optionally,
the time for the secondary etching is longer than the time for the primary etching, and
the protrusion length of the second tip portion is greater than the protrusion length of the first tip portion.

## Patentansprüche

1. Anzeigetafel (DP), Folgendes umfassend:
einen Transistor (TR);
ein lichtemittierendes Element (LD), Folgendes einschließend:
eine erste Elektrode (EL1);
eine lichtemittierende Schicht (EML), die auf der ersten Elektrode (EL1) angeordnet ist; und
eine zweite Elektrode (EL2), die auf der lichtemittierenden Schicht (EML) angeordnet ist, wobei die zweite Elektrode (EL2) elektrisch mit dem Transistor (TR) verbunden ist; und
eine Verbindungsverdrahtung (CN), die den Transistor (TR) mit der zweiten Elektrode (EL2) elektrisch verbindet, wobei die Verbindungsverdrahtung (CN) Folgendes einschließt:
einen ersten verbundenen Abschnitt (CE), der mit der zweiten Elektrode (EL2) elektrisch verbunden ist;
einen zweiten verbundenen Abschnitt (CD), der elektrisch mit dem Transistor (TR) verbunden ist; und
einen Verlängerungsabschnitt (CN), der sich von dem ersten verbundenen Abschnitt (CE) weg erstreckt und den ersten verbundenen Abschnitt (CE) und den zweiten verbundenen Abschnitt (CD) elektrisch verbindet, wobei jeder von dem ersten verbundenen Abschnitt (CE), dem zweiten verbundenen Abschnitt (CD) und dem Verlängerungsabschnitt (CN) Folgendes einschließt:
eine zweite Schicht (L2); und
eine dritte Schicht (L3), die auf der zweiten Schicht (L2) angeordnet ist,
der zweite verbundene Abschnitt (CD) und der Verlängerungsabschnitt (CN) einen ersten Spitzenabschnitt (TP1) einschließen,
der erste verbundene Abschnitt (CE) einen zweiten Spitzenabschnitt (TP2) einschließt, jeder von dem ersten Spitzenabschnitt (TP1) und dem zweiten Spitzenabschnitt (TP2) als ein Abschnitt definiert ist, bei dem ein Ende der dritten Schicht (L3) weiter auswärts vorsteht als ein Ende der zweiten Schicht (L2), und
vorstehende Längen des ersten Spitzenabschnitts (TP1) und des zweiten Spitzenabschnitts (TP2) voneinander verschieden sind.

2. Anzeigetafel nach Anspruch 1, wobei
eine isolierende Schicht auf der Verbindungsverdrahtung angeordnet ist, und
die isolierende Schicht einen offenen Bereich einschließt, der einen Abschnitt des ersten verbundenen Abschnitts freilegt, wobei wahlweise
der erste verbundene Abschnitt den ersten Spitzenabschnitt umfasst, und
der zweite Spitzenabschnitt in dem offenen Bereich definiert ist, und
wobei wahlweise der erste Spitzenabschnitt den offenen Bereich in einer Draufsicht nicht überlappt, und
die Vorsprungslänge des zweiten Spitzenabschnitts größer ist als die Vorsprungslänge des ersten Spitzenabschnitts.

3. Anzeigetafel nach Anspruch 2, wobei
der offene Bereich offene Bereiche einschließt, und
der zweite Spitzenabschnitt zweite Spitzenabschnitte einschließt, die den offenen Bereichen entsprechen.

4. Anzeigetafel nach Anspruch 2 oder Anspruch 3, wobei
der erste verbundene Abschnitt erste untergeordnete verbundene Abschnitte umfasst, und
die ersten untergeordneten verbundenen Abschnitte elektrisch miteinander verbunden sind.

5. Anzeigetafel nach Anspruch 4, wobei
die isolierende Schicht einen untergeordneten offenen Bereich umfasst, der einen Abschnitt von mindestens einem der ersten untergeordneten verbundenen Abschnitte freilegt, und
der zweite Spitzenabschnitt in dem untergeordneten offenen Bereich definiert ist.

6. Anzeigetafel nach Anspruch 5, wobei
der erste untergeordnete verbundene Abschnitt den ersten Spitzenabschnitt umfasst, und
der erste Spitzenabschnitt den untergeordneten offenen Bereich in einer Draufsicht nicht überlappt.

7. Anzeigetafel nach einem der Ansprüche 4 bis 6, wobei der erste verbundene Abschnitt einen untergeordneten Verlängerungsabschnitt umfasst, der die ersten untergeordneten verbundenen Abschnitte elektrisch verbindet.

8. Anzeigetafel nach Anspruch 7, wobei der untergeordnete Verlängerungsabschnitt den ersten Spitzenabschnitt umfasst.

9. Anzeigetafel nach einem der Ansprüche 5 bis 8, wobei
der untergeordnete offene Bereich untergeordnete offene Bereiche einschließt, und
der zweite Spitzenabschnitt zweite Spitzenabschnitte einschließt, die den untergeordneten offenen Bereichen entsprechen.

10. Anzeigetafel nach einem der vorhergehenden Ansprüche, wobei
die zweite Elektrode teilweise durch den zweiten Spitzenabschnitt getrennt ist, und
ein erstes Ende und ein zweites Ende, die getrennt sind, in der zweiten Elektrode definiert sind, wobei wahlweise
eine erste Schicht unterhalb der zweiten Schicht angeordnet ist,
das erste Ende die erste Schicht und die zweite Schicht an dem zweiten Spitzenabschnitt berührt, und
das zweite Ende auf der dritten Schicht angeordnet ist.

11. Anzeigetafel nach einem der vorhergehenden Ansprüche, wobei der erste verbundene Abschnitt, der Verlängerungsabschnitt und der zweite verbundene Abschnitt auf einer gleichen Schicht angeordnet sind.

12. Verfahren zum Herstellen einer Anzeigetafel, wobei das Verfahren Folgendes umfasst:
Bilden einer Antriebselementschicht (DDL), die einen Transistor (TR) und eine erste isolierende Schicht (10) auf einer Basislage (BS) einschließt;
Bilden eines Kontaktlochs (CNT1), das den Transistor (TR) teilweise freilegt;
Bereitstellen einer Verbindungsverdrahtung (CN), die durch das Kontaktloch (CNT1) auf der ersten isolierenden Schicht (10) elektrisch mit dem Transistor (TR) verbunden ist;
Bilden eines ersten Spitzenabschnitts durch primäres Ätzen (EC1) auf der Verbindungsverdrahtung (CN);
Bereitstellen einer zweiten isolierenden Schicht (60), welche die Verbindungsverdrahtung (CN) bedeckt;
Bilden eines ersten offenen Bereichs (OP1) auf der zweiten isolierenden Schicht (60), um den ersten Spitzenabschnitt (TP1) teilweise freizulegen, wodurch der erste Spitzenabschnitt, der durch den ersten offenen Bereich (OP1) freigelegt wird, als ein zweiter vorläufiger Spitzenabschnitt (PTP2) bereitgestellt wird; und
Bilden eines zweiten Spitzenabschnitts (TP2) durch sekundäres Ätzen (EC2) an dem zweiten vorläufigen Spitzenabschnitt (PTP2),
wobei die Verbindungsverdrahtung (CN) Folgendes einschließt:
eine erste Schicht (L1);
eine zweite Schicht (L2), die auf der ersten Schicht (L1) angeordnet ist; und
eine dritte Schicht (L3), die auf der zweiten Schicht (L2) angeordnet ist,
in jedem von dem ersten Spitzenabschnitt (TP1) und dem zweiten Spitzenabschnitt (TP2) ein Ende der dritten Schicht (L3) von einem Ende der zweiten Schicht (L2) vorsteht, und
Vorsprungslängen des ersten Spitzenabschnitts (TP1) und des zweiten Spitzenabschnitts (TP2) verschieden sind.

13. Verfahren nach Anspruch 12, wobei das Bereitstellen des zweiten vorläufigen Spitzenabschnitts das Freilegen des ersten Spitzenabschnitts umfasst.

14. Verfahren nach Anspruch 12 oder Anspruch 13, ferner Folgendes umfassend:
Bilden einer ersten Elektrode auf der zweiten isolierenden Schicht
Bilden einer Pixeldefinitionsfolie, auf der ein zweiter offener Bereich, der den zweiten Spitzenabschnitt freilegt, und eine Pixelöffnung, welche die erste Elektrode freilegt, definiert sind; und
Bereitstellen einer lichtemittierenden Schicht und einer zweiten Elektrode auf der ersten Elektrode,
wobei das Bereitstellen der zweiten Elektrode das Verbinden der zweiten Elektrode mit dem zweiten Spitzenabschnitt einschließt, wobei wahlweise die Verbindungsverdrahtung Folgendes umfasst:
einen ersten verbundenen Abschnitt, der elektrisch mit der zweiten Elektrode verbunden ist;
einen zweiten verbundenen Abschnitt, der elektrisch mit dem Transistor verbunden ist; und
einen Verlängerungsabschnitt, der sich von dem ersten verbundenen Abschnitt weg erstreckt und den ersten verbundenen Abschnitt und den zweiten verbundenen Abschnitt elektrisch verbindet, und
wobei wahlweise
das Bilden des ersten Spitzenabschnitts das Ätzen des ersten verbundenen Abschnitts, des Verlängerungsabschnitts und des zweiten verbundenen Abschnitts umfasst; und
das Bilden des zweiten Spitzenabschnitts das Ätzen einer Seite des ersten verbundenen Abschnitts umfasst.

15. Verfahren nach einem der Ansprüche 12 bis 14, wobei eine primäre Ätzzeit und eine sekundäre Ätzzeit verschieden sind, und
wobei wahlweise
die Zeit für das sekundäre Ätzen länger ist als die Zeit für das primäre Ätzen, und
die Vorsprungslänge des zweiten Spitzenabschnitts größer ist als die Vorsprungslänge des ersten Spitzenabschnitts.

## Revendications

1. Panneau d'affichage (DP) comprenant :
un transistor (TR) ;
un élément électroluminescent (LD) incluant :
une première électrode (EL1) ;
une couche électroluminescente (EML) disposée sur la première électrode (EL1); et
une seconde électrode (EL2) disposée sur la couche électroluminescente (EML), la seconde électrode (EL2) étant connectée électriquement au transistor (TR) ; et
un câblage de connexion (CN) qui connecte électriquement le transistor (TR) à la seconde électrode (EL2), dans lequel le câblage de connexion (CN) inclut :
une première partie connectée (CE) qui est connectée électriquement à la seconde électrode (EL2) ;
une seconde partie connectée (CD) qui est connectée électriquement au transistor (TR) ; et
une partie d'extension (CN) étendue depuis la première partie connectée (CE) et connectant électriquement la première partie connectée (CE) et la seconde partie connectée (CD), chacune de la première partie connectée (CE), la seconde partie connectée (CD) et la partie d'extension (CN) inclut :
une deuxième couche (L2) ; et
une troisième couche (L3) disposée sur la deuxième couche (L2),
la seconde partie connectée (CD) et la partie d'extension (CN) incluent une première partie de pointe (TP1),
la première partie connectée (CE) inclut une seconde partie de pointe (TP2), chacune de la première partie de pointe (TP1) et la seconde partie de pointe (TP2) est définie en tant que partie dans laquelle une extrémité de la troisième couche (L3) fait saillie à l'extérieur davantage qu'une extrémité de la deuxième couche (L2), et
des longueurs de saillie de la première partie de pointe (TP1) et de la seconde partie de pointe (TP2) sont différentes l'une de l'autre.

2. Panneau d'affichage selon la revendication 1, dans lequel
une couche isolante est disposée sur le câblage de connexion, et
la couche isolante inclut une région ouverte qui expose une partie de la première partie connectée, dans lequel, en option,
la première partie connectée comprend la première partie de pointe, et
la seconde partie de pointe est définie dans la région ouverte, et
dans lequel, en option, la première partie de pointe ne chevauche pas la région ouverte selon une vue en plan, et
la longueur de saillie de la seconde partie de pointe est plus grande que la longueur de saillie de la première partie de pointe.

3. Panneau d'affichage selon la revendication 2, dans lequel
la région ouverte inclut des régions ouvertes, et
la seconde partie de pointe inclut des secondes parties de pointe correspondant aux régions ouvertes.

4. Panneau d'affichage selon la revendication 2 ou la revendication 3, dans lequel
la première partie connectée comprend des premières sous-parties connectées, et
les premières sous-parties connectées sont mutuellement connectées électriquement.

5. Panneau d'affichage selon la revendication 4, dans lequel
la couche isolante comprend une sous-région ouverte qui expose une partie d'au moins l'une des premières sous-parties connectées, et
la seconde partie de pointe est définie dans la sous-région ouverte.

6. Panneau d'affichage selon la revendication 5, dans lequel
la première sous-partie connectée comprend la première partie de pointe, et
la première partie de pointe ne chevauche pas la sous-région ouverte selon une vue en plan.

7. Panneau d'affichage selon l'une quelconque des revendications 4 à 6, dans lequel la première partie connectée comprend une sous-partie d'extension qui connecte électriquement les premières sous-parties connectées.

8. Panneau d'affichage selon la revendication 7, dans lequel la sous-partie d'extension comprend la première partie de pointe.

9. Panneau d'affichage selon l'une quelconque des revendications 5 à 8, dans lequel
la sous-région ouverte inclut des sous-régions ouvertes, et
la seconde partie de pointe inclut des secondes parties de pointe correspondant aux sous-régions ouvertes.

10. Panneau d'affichage selon l'une quelconque des revendications précédentes, dans lequel
la seconde électrode est déconnectée partiellement par la seconde partie de pointe, et
une première extrémité et une seconde extrémité qui sont déconnectées sont définies dans la seconde électrode, dans lequel, en option,
une première couche est disposée au-dessous de la deuxième couche,
la première extrémité entre en contact avec la première couche et la deuxième couche au niveau de la seconde partie de pointe, et
la seconde extrémité est disposée sur la troisième couche.

11. Panneau d'affichage selon l'une quelconque des revendications précédentes, dans lequel la première partie connectée, la partie d'extension et la seconde partie connectée sont disposées sur une même couche.

12. Procédé pour fabriquer un panneau d'affichage, le procédé comprenant :
la formation d'une couche d'élément(s) de pilotage (DDL) incluant un transistor (TR) et une première couche isolante (10) sur une couche de base (BS) ;
la formation d'un trou de contact (CNT1) qui expose partiellement le transistor (TR) ;
la fourniture d'un câblage de connexion (CN) connecté électriquement au transistor (TR) au travers du trou de contact (CNT1) sur la première couche isolante (10) ;
la formation d'une première partie de pointe par gravure primaire (EC1) sur le câblage de connexion (CN) ;
la fourniture d'une seconde couche isolante (60) qui recouvre le câblage de connexion (CN) ;
la formation d'une première région ouverte (OP1) sur la seconde couche isolante (60) pour exposer partiellement la première partie de pointe (TP1), fournissant ainsi la première partie de pointe exposée par la première région ouverte (OP1) en tant que seconde partie de pointe préliminaire (PTP2) ; et
la formation d'une seconde partie de pointe (TP2) par gravure secondaire (EC2) sur la seconde partie de pointe préliminaire (PTP2),
dans lequel le câblage de connexion (CN) inclut :
une première couche (L1) ;
une deuxième couche (L2) disposée sur la première couche (L1) ; et
une troisième couche (L3) disposée sur la deuxième couche (L2),
dans chacune de la première partie de pointe (TP1) et la seconde partie de pointe (TP2), une extrémité de la troisième couche (L3) fait saillie depuis une extrémité de la deuxième couche (L2), et
des longueurs de saillie de la première partie de pointe (TP1) et de la seconde partie de pointe (TP2) sont différentes.

13. Procédé selon la revendication 12, dans lequel la fourniture de la seconde partie de pointe préliminaire comprend l'exposition de la première partie de pointe.

14. Procédé selon la revendication 12 ou la revendication 13, comprenant en outre :
la formation d'une première électrode sur la seconde couche isolante ;
la formation d'un film de définition de pixel(s) sur lequel une seconde région ouverte qui expose la seconde partie de pointe et une ouverture de pixel(s) qui expose la première électrode sont définies ; et
la fourniture d'une couche électroluminescente et d'une seconde électrode sur la première électrode,
dans lequel la fourniture de la seconde électrode inclut la connexion de la seconde électrode à la seconde partie de pointe, dans lequel, en option, le câblage de connexion comprend :
une première partie connectée qui est connectée électriquement à la seconde électrode ;
une seconde partie connectée qui est connectée électriquement au transistor ; et
une partie d'extension qui est étendue depuis la première partie connectée et qui connecte électriquement la première partie connectée et la seconde partie connectée, et
dans lequel, en option,
la formation de la première partie de pointe comprend la gravure de la première partie connectée, de la partie d'extension et de la seconde partie connectée ; et
la formation de la seconde partie de pointe comprend la gravure d'un côté de la première partie connectée.

15. Procédé selon l'une quelconque des revendications 12 à 14, dans lequel un temps de gravure primaire et un temps de gravure secondaire sont différents, et
dans lequel, en option,
le temps pour la gravure secondaire est plus long que le temps pour la gravure primaire, et
la longueur de saillie de la seconde partie de pointe est plus grande que la longueur de saillie de la première partie de pointe.
